# EUROPÄISCHE PATENTSCHRIFT

(11) **EP 2 289 097 B1**
(45) Veröffentlichungstag und Bekanntmachung des Hinweises auf die Patenterteilung: **10.10.2012**
(21) Anmeldenummer: 09765641.7
(22) Anmeldetag: 19.06.2009
(51) Int. Cl.: H01L 21/677

(54) **VERFAHREN UND VORRICHTUNG ZUM TRANSPORTIEREN VON GEGENSTÄNDEN**
METHOD AND DEVICE FOR TRANSPORTING OBJECTS
PROCEDE ET DISPOSITIF POUR LE TRANSPORT D'OBJETS

(30) Priorität: 19.06.2008 DE 102008028848
(43) Veröffentlichungstag der Anmeldung: 02.03.2011
(73) Patentinhaber: RENA GmbH, 78148 Gütenbach (DE)
(72) Erfinder: POTOFEEW, Vitalij, 78054 Villingen-Schwenningen (DE); BAREIS, Dirk, 78166 Donaueschingen (DE); KALTENBACH, Konrad, 78120 Furtwangen (DE); DELAHAYE, Franck, 79279 Vörstetten (DE)
(74) Vertreter: Stürken, Joachim
(86) Internationale Anmeldenummer: PCT/EP2009/004461
(87) Internationale Veröffentlichungsnummer: WO 2009/153061

(56) Entgegenhaltungen:
- GB-A- 1 268 913
- US-A- 3 870 460
- US-A- 4 681 776
- US-A- 4 874 273

## Beschreibung

Die vorliegende Erfindung betrifft Verfahren und Vorrichtungen zum Transportieren von im Wesentlichen flachen Gegenständen, wobei das Transportieren unter Verwendung einer strömenden Flüssigkeit erfolgt. Die Erfindung betrifft ferner Verfahren und Vorrichtungen zum Transportieren von derartigen Gegenständen, sowie zur gleichzeitigen nasschemischen Behandlung derselben.

Zunächst werden einige für das Verständnis der vorliegenden Erfindung wichtige Begriffe, die im Umgangssprachlichen keine klar umrissene Bedeutung haben, vor dem Hintergrund der Erfindung erläutert.

Das "Transportieren" eines flachen Gegenstandes umfasst sowohl die örtliche Veränderung der Position des zu transportierenden Gegenstandes, als auch das bloße Festhalten dieser Position ohne eine gleichzeitige Bewegung des Gegenstands, im Folgenden mit "Tragen" bezeichnet.

"Tragen" bzw. "Halten" bedeutet demnach, dass der flache Gegenstand im Wesentlichen stillsteht, also keine Transportgeschwindigkeit in irgendeiner Richtung vorliegt. Die Vorrichtung stellt die zum Halten benötigte (Trage-)Kraft bereit.

Um den Gegenstand in die gewünschte Richtung zu bewegen, muss dieser einem "Vorschub" ausgesetzt werden, sodass auf den Gegenstand eine entsprechende Vorschubkraft ausgeübt wird.

Damit der Gegenstand während des Vorschubs eine vorbestimmte Bahn oder Spur einhält, muss er zusätzlich "geführt" werden, weshalb auf den Gegenstand eine Führungskraft wirkt. Die für das "Führen" vorgesehene Führungskraft ist von der für die Transportbewegung notwendigen Vorschubkraft zu unterscheiden. Zur Vereinfachung wird nachfolgend anstatt von "Halten, Vorschieben und/oder Führen" zusammenfassend von "Transportieren" gesprochen.

"Mechanisch wirkend" bedeutet, dass die Übertragung der obengenannten Kräfte mit mechanischen Mitteln geschieht. Dies schließt alle nicht-fluidischen Verfahren ein, so z.B. Mittel aus Kunststoff oder Metall, aber auch solche aus sehr weiche, z.B. gelartigen Substanzen. Nicht eingeschlossen sind hingegen neben Flüssigkeiten auch gasförmige Medien.

"Frei beweglich" ist ein flacher Gegenstand dann, wenn er nicht durch mechanisch wirkende Mittel getragen, gehalten, oder geführt wird.

Zum Halten von flachen Gegenständen (im Folgenden auch Substrate oder kurz Gegenstände genannt) sind aus dem Stand der Technik beispielsweise Greifer, Auflagen, Kassetten usw. hinlänglich bekannt. Ein Halten von flachen Gegenständen ist unter anderem dann nötig, wenn diese Gegenstände einer stationären Behandlung unterzogen werden. Nachteilig an den bekannten Vorrichtungen ist insbesondere die Tatsache, dass das Substrat mechanisch berührt werden muss, um es entgegen der Schwerkraft abzustützen und/oder zu zentrieren, also in einer gewünschten Position zu halten. Diese Berührung kann typischerweise die Unterseite eines Substrats betreffen, sofern es auf Auflagen abgelegt wird. Alternativ oder zusätzlich kann sich diese Berührung auf die Substratkante(n) erstrecken, da gewöhnlich ein seitliches Ausbrechen des Substrats verhindert werden muss. Dies ist beispielsweise auch dann der Fall, wenn das Substrat von unten durch die strömende Behandlungsflüssigkeit angehoben wird, so dass es auf einem Flüssigkeitskissen schwebt und daher nicht dauerhaft auf (mechanisch wirkenden) Auflagen abgelegt sein muss. Ferner ist es auch nachteilig, wenn sich während des Haltens Kapillarkräfte zwischen den Auflagen und dem Gut bilden, da sich ein derartiger Kapillarspalt ohne zusätzliche Abstandhalter naturgemäß so lange verkleinert, bis sich eine mechanische Berührung zu den Auflagen einstellt.

Das schonende Führen von flachen Gegenständen ist im Rahmen von Transportvorrichtungen von Interesse, wie sie vorzugsweise zum Transport von Substraten innerhalb und zwischen Behandlungsanlagen eingesetzt werden. Ferner kann zeitgleich zum Transport eine vorzugsweise nasschemische Behandlung erfolgen, sofern die eingesetzte Flüssigkeit entsprechende Eigenschaften aufweist bzw. Substanzen oder Wirkstoffe beinhaltet.

In jedem der beschriebenen Fälle ist es notwendig, dass die eingesetzten Transporteinrichtungen die Substrate möglichst schonend von einer Behandlungsanlage zur nächsten, bzw. innerhalb einer Anlage beispielsweise in eine Behandlungsflüssigkeit hinein- und wieder aus ihr heraus transportieren. Die Transporteinrichtung muss dabei so beschaffen sein, dass die zu prozessierenden Bereiche (z.B. eine Seite des Substrats) während des Transports jederzeit frei bleiben und nicht abgedeckt werden. Während des Transports ist jederzeit sicherzustellen, dass die Gegenstände einer vorbestimmten Transportbahn folgen.

Insbesondere für den Fall einer über den bloßen Transport hinausgehenden Prozessierung müssen die Substrate sehr häufig während eines definierten Zeitraums mit der Transport- und/oder Behandlungsflüssigkeit, z.B. einer Reinigungs- oder Ätzlösung oder einer Beschichtungsflüssigkeit, in Kontakt gebracht werden. Während des Transports hat die Behandlungszeit wesentlichen Einfluss auf das Ergebnis. Um die gewünschte Behandlungszeit einzuhalten, werden im Stand der Technik insbesondere die folgenden zwei Methoden vorgeschlagen. Eine erste Methode sieht vor, dass das Substrat während der Behandlung im Wesentlichen still steht. Die Behandlungszeit wird durch die Dauer vorgegeben, während der die Transporteinrichtung das Substrat in der Behandlungsflüssigkeit belässt (Badanlage). Eine zweite Methode sieht vor, dass das Substrat während der Behandlung im Wesentlichen weitertransportiert wird, beispielsweise durch einen Transport entlang der Oberfläche der Behandlungsflüssigkeit, die sich in einem Behälter bestimmter Länge befindet (Durchlaufanlage, Durchlaufverfahren). Häufig werden dazu auch Niederhalter verwendet, die ein Aufschwimmen der häufig dünnen Substrate verhindern sollen. Im Hinblick auf hohe Durchsätze wird zumeist dem Durchlaufverfahren der Vorzug gegeben.

Eine zur Behandlung meist notwendige Durchmischung bzw. ein Austausch der Behandlungsflüssigkeit kann bei Badanlagen durch eine intermittierende Relativbewegung des bzw. der Substrate im Bad oder beispielsweise durch Düsen und dergleichen erreicht werden. Bei Durchlaufanlagen ist das Vorhandensein einer Relativgeschwindigkeit zwischen Substrat und Behandlungsflüssigkeit systemimmanent; ein darüber hinausgehender Austausch verbrauchter Flüssigkeit kann durch Düsen oder über Wehre oder dergleichen erfolgen.

Beim Transport des Substrats, sei es durch Ketten, Rollen, Walzen, Werkstückträger oder Greifer, ergibt sich jedoch eine Reihe von Problemen. Diese hängen vor allem mit einem möglichen Verlust der Spur der Substrate sowie mit den mechanischen Belastungen während des Transports zusammen.

Gründe für einen Spurverlust der zu transportierenden Substrate können beispielsweise sowohl mechanische Vibrationen sein, als auch Temperaturschwankungen, die zu einem Verzug in den Transporteinrichtungen führen können. Ein weiterer Grund liegt in der häufig geringen Masse der Substrate, die zu einer Reibkraft führt, welche zu einer sicheren Übertragung der Vorschubkräfte nicht ausreicht. Aus dem Spurverlust erwächst zunächst die Gefahr von Kollisionen mit weiteren Substraten während des Transports bzw. mit gewöhnlich in derartigen Anlagen ebenfalls vorhandenen (seitlichen) Führungen, die ein Ausbrechen der Substrate aus der gewünschten Bahn verhindern sollen. Zudem wird eine Aufnahme der Transportgüter für einen weiteren Verarbeitungsschritt oder eine Umlagerung erschwert, so dass diese unter Umständen nicht maschinell erfolgen kann.

Vorrichtungen zum Führen bzw. zum Transport von flachen Substraten sind aus dem Stand der Technik hinlänglich bekannt, wobei die beschriebenen Lösungen hinsichtlich des Tragens und/oder Führens immer auch einen mechanischen Kontakt zwischen zu transportierendem Gut und der Transportvorrichtung vorsehen.

Eine Transportvorrichtung, welche die oben bereits erwähnten Niederhalter aufweist, ist beispielsweise in der EP 1 354 830 B1 offenbart. Die Behandlungszeit bestimmt sich hierbei nach der (präzise einstellbaren) Transportgeschwindigkeit des Substrats und der Länge des Behälters, der die Behandlungsflüssigkeit enthält. Allerdings werden die Substrate durch mechanische Mittel gehalten, wodurch sich die vorhergehend beschriebenen Probleme ergeben. Weitere Nachteile ergeben sich bei der offenbarten wie auch bei ähnlichen Anlagen durch Wellen, deren Antriebe gewöhnlich außerhalb des Behandlungsbeckens angeordnet sind. Die Dichtungen, welche aufgrund der durch die Beckenwand hindurchragenden Wellen nötig sind, sind aufgrund der hohen Aggressivität der Behandlungsmedien wie z.B. HF oder HCl gegenüber Verschleiß besonders anfällig. Auch biegen sich die oft langen Wellen geringfügig durch, woraus Ungenauigkeiten beim Transport der Substrate resultieren.

Eine weitere Vorrichtung zum Transport von bruchempfindlichen, flachen Substraten zeigt die Druckschrift EP 1 354 830 A1 "Transportrollen, Niederhalter und Transportsystem". Die hier offenbarten Transportrollen weisen aufgrund ihrer Bauart und Materialwahl eine sehr geringe Empfindlichkeit gegenüber Temperaturschwankungen auf und ermöglichen einen schonenden Transport der flachen Substrate. Allerdings offenbart diese Erfindung neben den (mechanisch wirkenden) Rollen, auf welchen das zu transportierende Gut aufliegt, noch so genannte Spurhalter. Diese stehen insbesondere bei Spurverlust in seitlichem Kontakt mit den flachen Substraten, was jedoch aufgrund der daraus resultierenden mechanischen Beanspruchung unerwünscht ist.

Eine weitere Vorrichtung zum besonders schonenden Transport von flachen Substraten offenbart die Druckschrift DE 40 39 313 A1. Hier erfolgt der Transport über einen strömenden Flüssigkeitsfilm, der längs einer als Transportfläche ausgebildeten Oberfläche strömt und dabei die Substrate trägt und vorschiebt. Zur Erzeugung dieses Flüssigkeitsfilms sind in der Transportfläche schräge Spalte vorgesehen, durch welche Flüssigkeit von unten nach oben und somit gegen die Substratunterseite strömt. Eine Bewegungsrichtung wird durch eine Neigung der Spalte in Transportrichtung vorgegeben. Um sicherzustellen, dass die zu transportierenden Substrate auf der Transportvorrichtung verbleiben und nicht seitlich ausbrechen, weist die Vorrichtung entlang der Transportfläche beiderseits seitliche Kanten als Führungen auf. Bei einer Kollision mit den Führungen wirkt auf die Substrate eine ihnen entgegenwirkende Führungskraft, so dass das Substrat auf der Transportfläche geführt wird, auch wenn es seitlich abdriften sollte. Wie bereits ausgeführt ist das Vorliegen von seitlichen, mechanisch wirkenden Begrenzern jedoch unerwünscht. Zudem kann die Transportgeschwindigkeit nur sehr eingeschränkt eingestellt und eingehalten werden, indem der Druck des ausströmenden Transportmediums und/oder der Neigungswinkel der Spalte geändert wird. Durch das nicht vorhersagbare gelegentliche Kollidieren mit den Führungen verzögert sich die zunächst vorhandene Transportgeschwindigkeit, woraus eine entsprechend ungenaue Dauer des Transports und, im Falle einer gleichzeitigen z.B. nasschemischen Behandlung, ein ungleichmäßiges Behandlungsergebnis resultiert. Der die Transportgeschwindigkeit beeinflussende Neigungswinkel wird bei der Herstellung der Anlage konstruktiv vorgegeben und kann nicht nachträglich, z.B. in Abhängigkeit von der aktuellen Transportsituation, variiert werden. Ein vorübergehendes Anhalten der Substrate während des Transports ist ebenfalls nicht möglich, da die Substratunterseiten aufgrund des damit einhergehenden Fehlens des Transportmediums in mechanisch wirkenden, körperlichen Kontakt mit der Bodenplatte geraten würden, was unerwünscht ist. Aus diesen Gründen ist die offenbarte Transportvorrichtung lediglich ausschließlich zum Transport und nicht auch zur Prozessierung der Substrate vorgesehen.

Zwei ebenfalls auf ausströmenden Medien als Transportmittel beruhende Vorrichtung offenbaren schließlich die Druckschriften DE 693 065 81 T2 und US 4 874 273 A, nach welchen die zu transportierenden Gegenstände wie insbesondere flexible Bänder bzw. Wafer jedoch bevorzugt von gasförmigen Fluiden angeströmt und dadurch angehoben sowie ggf. mittels eines in eine Transportrichtung weisenden Fluidstroms bewegt werden. Auch diese Druckschriften offenbaren teilweise seitliche Anschläge zum Führen der Gegenstände. Zum korrekten Betrieb der Vorrichtung sind ganz bestimmte Druckverhältnisse einzuhalten, die u.a. durch die genaue Positionierung und Dimensionierung der Fluidauslässe bestimmt werden.

Auch die Druckschrift DE 693 049 17 T2 offenbart ein derartiges System, welches auf der Basis speziell geformter und im Wesentlichen senkrecht zur Transportebene angeordneter Austrittsöffnungen den Transport von Gegenständen erlaubt, ohne diese mechanisch zu kontaktieren. Die Druckschrift beschränkt sich jedoch auf den mechanischen Kontakt mit der Transportebene; zum seitlichen Führen der Gegenstände sind auch hier entsprechende Anschläge vorgesehen. Um Gegenstände auch anders als in horizontaler Lage transportieren zu können, stellt die Vorrichtung einen Differenzdruck bereit. Dieser führt dazu, dass der zu transportierende Gegenstand in Richtung zur Transportfläche gedrückt wird, ohne sie jedoch mechanisch zu berühren, da er gleichzeitig auf einem Luftkissen schwebt, welches mittels entsprechender, in der Transportfläche angeordneter Austrittsöffnungen erzeugt wird. Da der Differenzdruck nur senkrecht zur Oberfläche der Gegenstände wirkt, kann er nicht auch zu einer Führung der Gegenstände herangezogen werden. Ferner zielt die Vorrichtung lediglich auf einen Transport der Gegenstände ab, nicht jedoch auf die "Behandlung" im Sinne der vorliegenden Anmeldung.

Eine zusätzliche Rotation ermöglichen die Druckschriften US 3,761,002 oder EP 0 408 021 B1. Während in der US 3,761,002 Luftkissen offenbart werden, sind gemäß EP 0 408 021 B1 seitliche Einfassungen erforderlich, um ein seitliches Abdriften der zu transportierenden Gegenstände zu verhindern.

Andere aus dem Stand der Technik bekannte Vorrichtungen, bei denen lediglich der Auftrieb der Substrate durch eine entsprechende, von unten wirkendende Anströmung erzielt wird, erzeugen die zum Vorwärtstransport notwendige Kraftkomponente durch ein Gefälle. Die Problematik mechanisch wirkender Führungen, die ein seitliches Ausbrechen der Substrate verhindern, wird hierbei jedoch nicht gelöst. Auch ergibt sich durch die Nutzung des natürlichen Gefälles nur eine ungenügend genaue Einstellbarkeit der Transportgeschwindigkeit. Insbesondere ist es kaum möglich, bestimmte Bewegungsprofile vorzugeben und somit eine vorgegebene Behandlungszeit ausreichend genau einzuhalten. Auch ein vorübergehendes Anhalten der zu transportierenden Substrate ist ohne weitere Hilfsmittel nicht möglich.

Aufgabe der Erfindung ist es daher, ein Verfahren sowie eine Vorrichtung zum schonenden Transport flacher Substrate mit einer kontrollierten, bevorzugt konstanten Geschwindigkeit bereitzustellen, wobei insbesondere auf die seitlichen Kanten, Anschläge oder dergleichen als Führungshilfen verzichtet werden kann, so dass die Substrate weder an ihren Oberflächen noch an ihren Kanten in irgendeiner Weise mit mechanisch wirkenden Bauelementen zur Führung in Kontakt kommen. Das Verfahren und die Vorrichtung sollen für den Transport von einzelnen Substraten sowie für den Transport mehrerer, hintereinander und/oder nebeneinander positionierter Substrate geeignet sein. Bevorzugt soll gleichzeitig mit dem Transport auch eine nasschemische Prozessierung der Substrate möglich sein. Zur Einhaltung einer gewünschten Behandlungsdauer soll die Verweilzeit in der Vorrichtung präzise einstellbar sein. Es ist ferner bevorzugt, die Substrate nicht nur in Transportrichtung befördern zu können, sondern auch vorübergehend anzuhalten, wobei die Substrate dabei nicht oder nur unwesentlich in mechanisch wirkenden Kontakt mit der Umgebung treten.

Die Aufgabe wird durch das in Anspruch 1 vorgeschlagene Verfahren sowie durch die Bereitstellung der in Anspruch 6 vorgeschlagenen Vorrichtung gelöst. Demnach erfolgt das vom Transportieren umfasste Halten und Führen eines im Wesentlichen flachen und frei beweglichen Gegenstands wie z.B. eines Substrats auf einer Flüssigkeit unter Verwendung einer Vorrichtung, welche mindestens eine Behandlungsfläche mit mindestens einem Anströmbereich, und mindestens einen Ablaufbereich umfasst, wobei die zum Transport benötigte Flüssigkeit aus dem mindestens einen Anströmbereich der mindestens einen Behandlungsfläche derart ausgegeben wird, dass sie den flachen Gegenstand anströmt, bevor sie in den mindestens einen Ablaufbereich abläuft, wodurch zwischen dem flachen Gegenstand und der Grenze zwischen Behandlungsfläche und dem Ablaufbereich eine den Gegenstand selbstzentrierende Adhäsionskraft erzeugt wird, durch den der Gegenstand ohne seitliche Kanten, Begrenzer oder Anschläge etc. als mechanische Führungshilfen auf der Behandlungsfläche gehalten und spurgetreu geführt werden kann.

Nach einer bevorzugten Ausführungsform werden mechanische Mittel zum Vorschub bzw. zur Unterstützung des durch die Flüssigkeitsströmung bedingten Vorschubes des mindestens einen flachen Gegenstandes eingesetzt, die in Transportrichtung bewegbar sind oder angehalten werden können und insbesondere einer präzisen Kontrolle der Vorschubgeschwindigkeit sowie gegebenenfalls der Einhaltung einer gewünschten Standzeit zur Vornahme einer z.B. nasschemischen Behandlung dienen. Die seitliche Führung der Substrate wird erfindungsgemäß ausschließlich durch ein Kräftegleichgewicht erreicht, das aus Kräften insbesondere zwischen den Randbereichen der Behandlungsfläche und dem flachen Gegenstand (Schwerkraft, Auftrieb, durch den Flüssigkeitsfilm vermittelte Adhäsion) und der Oberflächenspannung der eingesetzten Flüssigkeit (Kohäsion) resultiert.

Das erfindungsgemäße Verfahren sowie die erfindungsgemäß vorgeschlagene Vorrichtung sind sowohl im Rahmen einer stationären Behandlung als auch im Rahmen eines Transports der Substrate, ggf. mit einer gleichzeitigen, unter einer Transportgeschwindigkeit stattfindenden Behandlung, vorteilhaft geeignet. Der Transport kann sowohl innerhalb einer als auch zwischen mehreren Behandlungsanlagen erfolgen. Die Anwendung der erfindungsgemäßen Lehre ist ferner insbesondere in solchen Behandlungsanlagen von Vorteil, in denen Gegenstände oder Substrate hochreinen nassen Prozessen unter Verwendung von Wasser, insbesondere von hochreinem Wasser, oder von flüssigen Chemikalien unterzogen werden. Bei diesen Anwendungen ist es meist wichtig, dass die Substratoberflächen zu keinem Zeitpunkt abtrocknen, da dadurch die Oberflächenreinheit der Substrate eingeschränkt werden könnte. Weitere bevorzugte Ausführungsformen sind den jeweiligen abhängigen Ansprüchen sowie der nachfolgenden detaillierten Beschreibung und den Figuren zu entnehmen.

Die vorliegende Erfindung basiert auf der Erkenntnis, dass im Wesentlichen frei bewegliche flache Gegenstände auf einer Flüssigkeit wie insbesondere auf einer strömenden Flüssigkeit oder einem Flüssigkeitsfilm gehalten und spurtreu transportiert werden können, ohne dass zum Führen der Gegenstände seitliche Begrenzer, Kanten oder andere mechanische Führungshilfen als bauliche Komponenten einer entsprechenden Vorrichtung benötigt werden.

Im Rahmen der zur Erfindung durchgeführten Experimente hat sich überraschenderweise herausgestellt, dass ein zum Transportieren von Substraten eingesetzter Flüssigkeitsfilm, der durch eine strömende Flüssigkeit gebildet wird, derart bereitgestellt werden kann, dass ein selbsttätiges Halten und Führen des zu transportierenden, im Wesentlichen flachen Gegenstandes auf einer Halte- oder Transportvorrichtung erfolgt.

Da im Rahmen des Transports gewünschtenfalls auch gleichzeitig eine Behandlung erfolgen kann, wird im Folgenden vereinheitlichend von einer "Behandlungsfläche" gesprochen, wobei eine erfindungsgemäße "Behandlung" auch einen "Transport" umfasst oder ausschließlich diesen betrifft.

Wesentlicher Aspekt der vorliegenden Erfindung ist das Bereitstellen von Kräften, die für das sichere Halten und insbesondere für das spurtreue Führen eines Gegenstandes auf und entlang der Behandlungsfläche zuständig sind, also beispielsweise das Beabstanden des Gegenstands von einer Behandlungsfläche sowie das Einhalten eines vorbestimmten Ortes oder einer vorbestimmten Spur im Rahmen einer beispielsweise becken- oder rinnenartigen Vorrichtung.

Nach einer ersten Ausführungsform dient das erfindungsgemäße Verfahren im Rahmen der vorstehenden Definitionen nur der Bereitstellung der zum sicheren Halten und Führen eines flachen Gegenstandes benötigten Halte- und Führungskräfte.

Nach einer zweiten Ausführungsform dient das erfindungsgemäße Verfahren zusätzlich der Erzeugung einer für den Vorschub notwendigen Vorschubraft.

Nach beiden Ausführungsformen erfolgt das Halten und spurgetreue Führen ausschließlich unter Verwendung einer vorzugsweise strömenden Flüssigkeit, weshalb auf mechanisch, also nicht-fluidisch wirkende seitlicher Kanten, Begrenzer oder andere Mittel zum Halten und Führen der Gegenstände verzichtet werden kann. Auf diese Weise wird eine mechanische Beschädigung insbesondere der seitlichen Kanten der flachen Gegenstände zuverlässig vermieden. Ferner erfolgt das Halten und Führen auch ohne ober- und/oder unterhalb des flachen Gegenstandes angeordnete, mechanisch wirkende Begrenzer, Führungshilfen, Halter oder dergleichen, wie beispielsweise Haltevorrichtungen, Greifer, Vakuumchucks usw. Auf diese Weise wird eine mechanische Beschädigung der gewöhnlich sehr berührungsempfindlichen flächigen Seiten der Gegenstände weitgehend unterbunden.

Erfindungsgemäß wird das Führen der Gegenstände durch ein Zusammenwirken zweier Fluide unterschiedlichen Typs, also einer Flüssigkeit und eines Gases, bewirkt, wobei das Gas nicht von der Behandlungsfläche ausgegeben wird, sondern die umgebende Raumluft betrifft. In dieser Situation bildet sich zwischen den Flächen des flachen Gegenstands und der Behandlungsfläche die zum Halten und Führen benötigte Adhäsion aus. Dies ist beispielsweise dann nicht der Fall, wenn der Gegenstand vollständig von ein und derselben Flüssigkeit umgeben ist. Es ist dabei unerheblich, ob geringe Mengen des einen Fluidtyps im anderen enthalten sind, beispielsweise Gasblasen in einer Flüssigkeit.

Erfindungsgemäß tritt die strömende Flüssigkeit aus mindestens einem Anströmbereich aus, welcher sich auf mindestens einer Behandlungsfläche befindet. Die strömende Flüssigkeit ist dabei so gerichtet, dass sie den flachen Gegenstand anströmt. Dabei ist es möglich, dass die Flüssigkeit im Wesentlichen senkrecht aus der Behandlungsfläche und somit ebenfalls senkrecht auf den parallel zur Behandlungsfläche liegenden flachen Gegenstand auftrifft und diesen lediglich anhebt. Die Dicke des Flüssigkeitsfilms beträgt bevorzugt 0,1 bis 3 mm. Alternativ ist es möglich, dass die Flüssigkeit unter einem Winkel aus der Behandlungsfläche ausströmt, so dass eine zusätzliche Bewegungskomponente auf den Gegenstand wirkt.

Die Flüssigkeit läuft anschließend in mindestens einen Ablaufbereich. Dieser Ablaufbereich kann beispielsweise durch eine Überlaufkante im Randbereich der Behandlungsfläche, oder auch durch entsprechende Ablauföffnungen jenseits der Behandlungsfläche gekennzeichnet sein.

Das Führen und Halten eines Substrates erfolgt erfindungsgemäß ohne jeglichen Kontakt mit mechanischen Mitteln. Auch wenn zum Vorschub ein oder mehrere Mitnehmer die Kante des Substrates berühren können, sind diese Mitnehmer keine mechanischen Mittel zum Führen und/oder Halten des Substrates. Solange sich das Substrat vollständig über der Behandlungsfläche befindet und von der ausgegebenen Flüssigkeit getragen wird, ist es frei beweglich. Dies ist zum Beispiel der Fall, wenn das Substrat schmaler als die Breite der Behandlungsfläche ist. Wenn das Substrat an den Ablaufbereich gelangt oder die Grenze zwischen der Behandlungsfläche und diesem Ablaufbereich überschreitet, bildet sich erfindungsgemäß ein Kräftegleichgewicht zwischen dem flachen Gegenstand und dem mindestens einen Ablaufbereich aus. Dieses Kräftegleichgewicht, welches insbesondere auf einer Ausbildung von Adhäsionskräften zwischen der Fläche und dem Rand des Ablaufbereiches beruht, führt dazu, dass der flache Gegenstand selbsttätig, also ohne Einwirkung mechanischer Hilfsmittel, eine bevorzugte Position einnimmt, die erfindungsgemäß der gewünschten, stationären bzw. der vorbestimmten Transportbahn folgenden Position entspricht. Er kehrt ferner auch selbsttätig in diese bevorzugte Position zurück, wenn er beispielsweise mittels externer Krafteinwirkung aus dieser ausgelenkt wird. Derartige Kräfte können insbesondere beim Transport des Gegenstandes auf diesen wirken und ohne die erfindungsgemäße selbsttätige Rückbewegung zu einem Verlassen der vorbestimmten Transportbahn führen.

Es ist dabei notwendig, dass der Ablaufbereich derart bemessen ist, dass über ihn mindestens die Menge an Flüssigkeit abgeführt werden kann, welche im Anströmbereich ausgegeben wird.

Der erfindungsgemäße Effekt kann alternativ, zusätzlich oder ausschließlich auch dadurch erreicht werden, dass im Ablaufbereich Düsen oder gleichwirkende Mittel angeordnet sind, aus denen eine gerichtete Strömung so austritt, dass das Niveau der Flüssigkeit in diesem Bereich angehoben wird, so dass sich ein eine fluidische Begrenzung darstellendes "Flüssigkeitswehr" bildet, über welches der flache Gegenstand nur unter Anwendung erheblicher äußerer Einwirkungen hinweg gleiten kann. Aus diesen Düsen kann eine Flüssigkeit, ein Gas, oder ein Flüssigkeit/Gas-Gemisch ausgegeben werden. Die Ausgabe kann kontinuierlich oder in Pulsen erfolgen, so dass in ersten Fall ein durchgehender Strahl, im zweiten Fall beispielsweise einzelne Flüssigkeitspulse oder in Flüssigkeit eingebettete Gasblasen ausgebildet werden, welche das Anheben des Niveaus besonders effektiv ermöglichen und zudem beim Auflösen an der Flüssigkeitsoberfläche eine Vielzahl kleiner Wellen erzeugen, durch welche der flache Gegenstand vom Flüssigkeitswehr zurück zur Behandlungsfläche gedrängt wird. Diese Art des Transports ist bevorzugt dann anzuwenden, wenn eine Benetzung der Substratoberfläche erlaubt ist.

Neben einer seitlichen Anordnung können derartige Wehre alternativ oder zusätzlich auch senkrecht zur Transportrichtung angeordnet sein und bei Betrieb zu einem Anhalten der transportierten Gegenstände genutzt werden. Im einfachsten Fall werden derartige Wehre durch eine Reihe von Stopp-Düsen gebildet, die im Wesentlichen über die gesamte Breite der Behandlungsfläche senkrecht aus ihr in Richtung der Substratoberfläche abstrahlen.

Nach einer bevorzugten Ausführungsform des erfindungsgemäßen Verfahrens ist die Flüssigkeit, die dem Halten und Führen des flachen Gegenstands dient, eine Behandlungsflüssigkeit. Auf diese Weise kann gleichzeitig zum Halten und Führen auch eine Behandlung des flachen Gegenstands erfolgen. Als Behandlungen kommen insbesondere Reinigungs-, Beschichtungsoder Ätzschritte in Frage.

Nach einer besonders bevorzugten Ausführungsform greifen die das Kräftegleichgewicht verursachenden Einzelkräfte symmetrisch am flachen Gegenstand an. Das bedeutet, dass der oder die Ausström- und/oder Ablaufbereiche symmetrisch auf bzw. zur Behandlungsfläche und somit zu dem zu haltenden oder zu führenden Gegenstand angeordnet sind. Handelt es sich beispielsweise um einen quadratischen oder runden flachen Gegenstand, so kann im Falle eines Haltens desselben besonders bevorzugt ein ebenfalls quadratischer oder runder, umlaufender oder auch regelmäßig unterbrochen ausgestalteter Ablaufbereich bereitgestellt werden. Für das Führen ist es besonders bevorzugt, dass die verwendete Vorrichtung seitlich an die Behandlungsfläche anschließend zwei im Wesentlichen gleich gestaltete und gegenüberliegend angeordnete Ablaufbereiche umfasst, sodass die mindestens eine Behandlungsfläche mit dem mindestens einen, bevorzugt ebenfalls symmetrisch angeordneten Anströmbereich seitlich von den beiden Ablaufbereichen eingeschlossen ist, wodurch sichergestellt wird, dass der zu führende flache Gegenstand an den entsprechenden, in die Richtung der Ablaufbereiche weisenden Kanten im Wesentlichen die gleichen Kräfte erfährt.

Nach einer anderen Ausführungsform greift das Kräftegleichgewicht nicht symmetrisch am flachen Gegenstand an. Dies kann beispielsweise dann der Fall sein, wenn der oder die Ablaufbereiche nicht symmetrisch zum flachen Gegenstand angeordnet ist bzw. sind, oder wenn im Falle eines Führens (in Vorschubrichtung gesehen) nur ein außermittig, beispielsweise an einem seitlichen Rand einer entsprechenden rinnenartigen Vorrichtung einseitig angeordneter Ablaufbereich vorgesehen ist. Auch in diesem Fall haben Experimente gezeigt, dass sich das erfindungsgemäße Kräftegleichgewicht derart ausbildet, dass der Abstand des flachen Gegenstands zum Ablaufbereich im Wesentlichen konstant bleibt, so dass ein erfindungsgemäßes Führen des Gegenstands möglich ist. Gegebenenfalls kann es erforderlich sein, dass die Austrittsdüsen im Anströmbereich der Behandlungsfläche auf die Überlauf kante ausgerichtet sind, damit das Substrat in diese gewünschte Richtung geführt wird und nicht unkontrolliert zur gegenüberliegenden Grenze der Behandlungsfläche, an der sich dann kein Ablaufbereich befindet, wegdriften kann.

Nach einer bevorzugten Ausführungsform des erfindungsgemäßen Verfahrens ist vorgesehen, dass zum Bewegen des flachen Gegenstandes zusätzlich zu dem oben beschriebenen Kräftegleichgewicht eine Vorschubkraft auf denselben ausgeübt wird.

Nach einer besonders bevorzugten Ausführungsform wird die Vorschubkraft auf den flachen Gegenstand durch die strömende Flüssigkeit ausgeübt. Diese Vorschubkraft wird unabhängig von der zum Halten oder Führen notwendigen Kraft bereitgestellt und wird durch ein Strömen einer Flüssigkeit in die gewünschte Bewegungsrichtung erreicht. Bevorzugt wird dazu dieselbe Flüssigkeit benutzt, welche auch für das Halten und Führen verwendet wird. Besonders bevorzugt ist es, wenn die Flüssigkeit auch aus denselben Austrittsöffnungen des oder der Anströmbereiche strömt. Die in Bewegung versetzte Flüssigkeit wirkt dabei als fluidischer Mitnehmer für den jeweiligen flachen Gegenstand. Die bevorzugte Bereitstellung der Vorschubkraft durch das gerichtete Strömen der Flüssigkeit stellt ein besonders effektives Mittel zur Vermeidung mechanischer Schäden an den meist bruchempfindlichen flachen Gegenständen dar.

Insbesondere für den Fall einer Bereitstellung des Vorschubs mittels der strömenden Flüssigkeit ist es ferner bevorzugt, dass die Anlieferung in den Bereich der erfindungsgemäßen Vorrichtung und insbesondere die Übergabe der Substrate an die eigentliche Transporteinrichtung bereits mit der innerhalb der erfindungsgemäßen Vorrichtung vorgesehenen Vorschubgeschwindigkeit erfolgt. Auf diese Weise lassen sich Probleme bei der Übergabe weitgehend vermeiden. Dies ist vor allem dann von Vorteil, wenn unterschiedlich schwere Substrate in die Vorrichtung einfahren, da die Substrate bei Einwirkung einer jeweils gleichbleibenden Vorschubströmung unterschiedlich schnell beschleunigt werden. Die daraus resultierenden unterschiedlichen Geschwindigkeiten können im ungünstigsten Fall zu Kollisionen aufeinander folgender Substrate führen.

Im Falle einer Prozessierung der Substrate in Durchlaufanlagen haben Versuche gezeigt, dass das Behandlungsergebnis vor allem davon abhängig ist, dass die Behandlungsdauer exakt eingehalten wird. Alleine der schonende Transport mittels einer Transportflüssigkeit, die gleichzeitig auch Behandlungsflüssigkeit war, führte gewöhnlich noch zu keiner ausreichend genauen Einhaltung der Behandlungszeit. Ein gleichzeitiges Transportieren und Prozessieren von Substraten unter Verwendung desselben Mediums war in bestimmten Fällen nur unter der Maßgabe möglich, dass eine Trennung der beiden Funktionen "Prozessierung" und "Transport" ermöglicht wurde. Nur auf diese Weise wurde die Vorgabe bzw. das Einhalten einer Transportgeschwindigkeit im Wesentlichen unabhängig von einer durch die Erzeugung des Flüssigkeitsfilms aufgeprägten Grundgeschwindigkeit der Substrate erreicht.

Daher ist nach einer anderen Ausführungsform des erfindungsgemäßen Verfahrens vorgesehen, dass die Vorschubkraft ausschließlich oder zusätzlich wie unterstützend durch eine mechanisch wirkende Vorschubeinrichtung bereitgestellt wird, wobei diese Einrichtung natürlich auch als Stopp- oder Bremseinrichtung eingesetzt werden kann, sofern einem durch Flüssigkeitsströmung erzeugtem Vorschub entgegen gewirkt werden soll. Diese Einrichtung berührt den jeweiligen flachen Gegenstand bevorzugt an seiner entgegen der Vorschubrichtung weisenden und/oder an der in Vorschubrichtung weisenden Kante. Für den Fall runder Substrate werden bevorzugt diejenigen Teile der umlaufenden Kante berührt, die direkt in Vorschubrichtung bzw. gerade entgegen derselben ausgerichtet sind. Bevorzugt ist die Form der das Substrat berührenden Teile der Vorschubeinrichtung an die Außenkontur des flachen Gegenstands angepasst. Auf diese Weise kann die Vorschubeinrichtung ein Abbremsen bzw. ein Beschleunigen des jeweiligen Gegenstandes erreichen, wobei dies im Wesentlichen unabhängig von einer ggf. ebenfalls vorhandenen, durch den strömenden Flüssigkeitsfilm hervorgerufenen Vorschubgeschwindigkeit geschieht. Auf diese Weise ist es demnach auch möglich, die Verweildauer in einer Prozessierungsanlage unabhängig von einer eventuell vorhandenen Grundströmung einzustellen, die von der strömenden Flüssigkeit hervorgerufen wird.

Besonders bevorzugte Vorschubeinrichtungen sind im Rahmen der erfindungsgemäßen Vorrichtung detailliert beschrieben. Für den Fall einer mehr- wie insbesondere zweiteiligen Vorschubeinrichtung, bei der eine Übergabe des Substrats von einem ersten zu einem nachfolgenden Teil der Vorschubeinrichtung erfolgt, stellt sich der entsprechende Vorgang wie nachstehend beschrieben dar, wobei sich die Beschreibung beispielhaft auf den Transport entlang eines Segmentes stützt. Es ist klar, dass mit einer derartigen Vorschubeinrichtung auch andere Längenabschnitte überbrückt werden können. Besonders vorteilhaft wird eine solche Vorschubeinrichtung daher innerhalb von Behandlungsanlagen eingesetzt, so dass sinngemäß der Begriff des "Segments" mit dem Begriff der "Behandlungsanlage" austauschbar ist.

Zunächst wird das Substrat ausreichend weit in den Eingang eines Segments eingeführt, und zwar mindestens so weit, bis das Substrat mit seiner nach unten weisenden Seite von der Flüssigkeitsschicht des Fluidkissens ohne mechanischen Kontakt mit der Behandlungsfläche getragen wird. Das Einführen selber kann daher auch mit anderen als den erfindungsgemäß vorgesehenen Mitteln erfolgen; es ist jedoch bevorzugt, dass auch stromaufwärts vor einer mit der erfindungsgemäßen Vorrichtung ausgestatteten Behandlungseinrichtung bereits Vorrichtungen zum Einsatz kommen, welche einen erfindungsgemä-βen, weil besonders schonenden und kontrollierbaren Transport des Substrates erlauben. Ferner ist bevorzugt, dass die Anlieferungsgeschwindigkeit an die gewünschte Vorschubgeschwindigkeit angepasst ist. Das Einführen ist dann ausreichend weit fortgeschritten, wenn sich die auf die breiteste Stelle des Substrates folgende Verjüngung desselben zumindest geringfügig im Bereich des Segmentes befindet. Mit anderen Worten müsste beispielsweise der Mittelpunkt eines runden Substrates zumindest etwas über die Grenze des Segments in den Bereich desselben hineinragen. Nur dann ist es möglich, mit der erfindungsgemäßen Vorschubeinrichtung das Substrat weiter in den Bereich des Segmentes hinein zu bewegen.

Nun erfolgt eine Steuerung der Mitnehmer eines ersten Teils der bevorzugt mehrteiligen Vorschubeinrichtung dergestalt, dass eine Berührung der vorzugsweise hinteren bzw. der im hinteren Bereich liegenden Kante des Substrates hergestellt wird. Wie erwähnt ist dies nur dann möglich, wenn das Substrat sich ausreichend weit im Bereich des Segmentes befindet.

Dann kann der Transport des Substrates mit den Mitnehmern des ersten Teils einer mehrteiligen Vorschubeinrichtung innerhalb des Bereichs des Segmentes erfolgen. Auf diesem Weg kann erfindungsgemäß die Behandlung des Substrats stattfinden. Es ist selbstverständlich auch möglich, den Transport zu unterbrechen, um beispielsweise eine längere Verweilzeit des Substrats im Bereich des Segmentes zu ermöglichen. Während der gesamten Zeit ist es jedoch erfindungsgemäß bevorzugt, dass ein kontinuierlicher Kontakt zwischen den Mitnehmern und dem Substrat besteht.

Anschließend kann eine Übergabe des Substrats an mindestens einen weiteren Teil einer mehrteiligen Vorschubeinrichtung stattfinden. Hierzu sind die Mitnehmer beider Teile derart zu steuern, dass der bzw. die Mitnehmer des ersten Teils die Kante des Substrates solange berühren, bis diese Kante von dem bzw. den Mitnehmern des weiteren Teils ebenfalls berührt wird. Zumindest für einen kurzen Moment berühren demnach sowohl der bzw. die abgebenden als auch der bzw. die übernehmenden Mitnehmer das Substrat und stellen so sicher, dass es zu keinem Zeitpunkt zu einer unkontrollierten Bewegung des Substrats kommt. Eine Führung des Substrats durch die Mitnehmer ist hingegen nicht notwendig, da hier die zuvor beschriebene erfindungsgemäße Lehre zur Anwendung kommt, wodurch ein seitliches Ausbrechen des Substrats verhindert wird. Falls jeweils mehr als ein abgebender und übernehmender Mitnehmer vorgesehen ist, sind diese erfindungsgemäß bevorzugt in seitlicher Richtung jeweils unterschiedlich voneinander beabstandet, damit eine Kollision der Mitnehmer unterschiedlicher Teile der Vorschubeinrichtung während der Übergabe des Substrats ausgeschlossen ist.

Nach erfolgter Übergabe findet der weitere Transport des Substrates mit dem bzw. den Mitnehmern des weiteren Teils der mehrteiligen Vorschubeinrichtung innerhalb des Segmentes statt. Selbstverständlich kann auch während dieses weiteren Transports eine Behandlung des Substrats erfolgen. Auch ein Anhalten des Vorschubs ist gewünschtenfalls möglich.

Schließlich wird das Substrat ausreichend weit aus dem Ausgang eines Segments herausgeführt. Dieses Ausführen ist dann ausreichend, wenn sich die auf die breiteste Stelle des Substrates folgende Verjüngung desselben zumindest geringfügig außerhalb des Bereichs des Segmentes befindet. Dieser Schritt ist demnach in Analogie zum weiter oben beschriebenen ausreichenden Hineinführen des Substrats in den Bereich des Segmentes zu sehen. Für den Fall, dass sich an das Segment ein weiteres Segment der erfindungsgemäßen Art anschließt, kann dieses das Substrat nur dann übernehmen, wenn das Substrat wie vorstehend beschrieben ausreichend weit in dieses hineingeführt wurde, was gleichbedeutend mit einem ausreichendem Herausführen des Substrats aus dem vorhergehenden Segment ist.

Nach einer weiteren Ausführungsform ist vorgesehen, dass die Mitnehmer eines weiteren Teils der mehrteiligen Vorschubeinrichtung ein erstes Substrat durch den Ausgang aus dem Bereich eines Segmentes heraus führen, während die Mitnehmer eines ersten Teils der mehrteiligen Vorschubeinrichtung ein zweites Substrat in diesen Bereich einführen. Dadurch können mehrere Substrate gleichzeitig durch das Segment geführt werden, so dass eine weitere Verbesserung der Wirtschaftlichkeit erreicht wird. Durch die separate Steuerbarkeit der Teile der Vorschubeinrichtung ist es auch möglich, ein Substrat bereits in den Bereich eines Segments zu transportieren, während ein zweites Substrat vorübergehend im Bereich dieses Segmentes stillsteht. Für diesen Fall ist es lediglich notwendig sicherzustellen, dass rechtzeitig zur Übergabe eines Substrats auch entsprechende Mitnehmer bereitstehen. Dies kann sowohl durch ein rechtzeitiges Ausführen des behandelten Substrats aus dem Bereich des Segments, oder auch durch das Vorsehen weiterer bzw. zusätzlicher Teile der mehrteiligen Vorschubeinrichtung geschehen.

Nach einer besonders bevorzugten Ausführungsform des erfindungsgemäßen Verfahrens ist vorgesehen, dass mindestens die Übergabegeschwindigkeiten und ggf. die auf die jeweiligen Substrate wirkenden Vorschub- und ggf. Strömungsgeschwindigkeiten mehrerer aufeinander folgender Segmente miteinander synchronisiert sind. Auf diese Weise ist sichergestellt, dass aus einem stromaufwärts angeordneten Segment ausgeführte Substrate sicher und kontrolliert an das darauf folgende Segment übergeben werden. Insbesondere ist sichergestellt, dass es zu keinen Kollisionen aufgrund sich aufstauender Substrate oder in ungünstiger Position befindlicher Mitnehmer kommen kann.

Die erfindungsgemäß vorgesehene strömende Flüssigkeit kann den flachen Gegenstand wahlweise ein- oder beidseitig anströmen. Im Falle einer einseitigen Anordnung befindet sich der Flüssigkeitsfilm unterhalb des flachen Gegenstands, so dass letzterer wie auf einem Flüssigkeitskissen gelagert ist.

Im Falle einer beidseitigen Anordnung wird der zu haltende und zu führende flache Gegenstand von beiden Seiten durch die strömende Flüssigkeit angeströmt, wobei die entsprechenden Behandlungsflächen und Anströmbereiche sowohl unterhalb als auch oberhalb des Gegenstandes angeordnet sind. Dementsprechend kann auch von einer sandwichartigen Anordnung des flachen Gegenstands gesprochen werden.

Es ist dabei sowohl möglich, dass der Vorschub auf den Gegenstand mittels der strömenden Flüssigkeit selber, als auch mittels einer oder mehrerer zusätzlicher Vorschubeinrichtungen bereitgestellt wird. Im ersteren Fall kann die den Vorschub erzeugende Strömung der Flüssigkeit auch durch zusätzliche, bevorzugt seitlich angeordnete Öffnungen wie z.B. Düsen bereitgestellt werden. Ebenso ist es bevorzugt, dass für den letzteren Fall seitlich in den mit Flüssigkeit gefüllten Bereich eingreifende Vorschubeinrichtungen vorzusehen sind, wobei alternativ oder auch zusätzlich Öffnungen wie insbesondere Längsschlitze in mindestens einer der beiden Behandlungsflächen vorzusehen sind, durch welche die Mitnehmer der Vorschubeinrichtungen durchgreifen und auf den Gegenstand einwirken können, ohne selber vollständig oder überwiegend dort angeordnet sein zu müssen.

Nach einer weiteren Ausführungsform umfasst das erfindungsgemäße Verfahren noch einen Schritt zur Ultra- und/oder Megaschallbehandlung des flachen Gegenstandes. Dieser Schritt kann vor, während oder nach einer ggf. vorhandenen Bewegung des flachen Gegenstandes erfolgen, wobei es bevorzugt ist, dass die Ultra- oder Megaschallbehandlung während der Bewegung des flachen Gegenstands durchgeführt wird.

Ferner umfasst die Erfindung auch eine Vorrichtung zur Durchführung des erfindungsgemäßen Verfahrens.

Dementsprechend offenbart die Erfindung eine Vorrichtung zum Transportieren eines im Wesentlichen flachen und frei beweglichen Gegenstands auf einer Flüssigkeit, wobei erfindungsgemäß natürlich auch mehrere Substrate nebeneinander und/oder aufeinander folgend transportiert werden können. Die Vorrichtung umfasst dabei mindestens eine Behandlungsfläche, welche mindestens einen Anströmbereich mit einer Mehrzahl von Durchtrittsöffnungen aufweist, aus welchen die Flüssigkeit den flachen Gegenstand anströmt, und mindestens einen Ablaufbereich, in welchen die Flüssigkeit nach dem Anströmen abläuft. Erfindungsgemäß umfasst die Vorrichtung keine nicht-fluidischen Kanten, Begrenzer oder andere mechanische Führungshilfen zum Führen des flachen Gegenstands, da der flache Gegenstand ausschließlich durch den Strom aus Flüssigkeit gehalten und geführt wird.

Hinsichtlich der speziellen Ausgestaltung der erfindungsgemä-βen Vorrichtung wird auf die vorhergehenden Ausführungen zur Erläuterung und Durchführung des erfindungsgemäßen Verfahrens verwiesen.

Der mindestens eine Anströmbereich der mindestens einen Behandlungsfläche soll erfindungsgemäß eine Strömung von Flüssigkeit erzeugen, die gegen den flachen Gegenstand gerichtet ist und ihn (für den Fall eines Anströmens von Unten) anhebt, ohne dass hierzu mechanisch wirkende Mittel nötig sind. Hierzu umfasst der Anströmbereich entsprechende Durchtrittsöffnungen, besonders bevorzugt eine Vielzahl derselben. Aus diesen Durchtrittsöffnungen wird die Flüssigkeit unter gewissem Druck und mit einer gewissen Strömungsgeschwindigkeit ausgegeben. Die Durchtrittsöffnungen können dabei bevorzugt runde oder rechteckige, besonders bevorzugt spalt- oder schlitzförmige Querschnitte aufweisen. Sie können statistisch verteilt oder regelmäßig angeordnet sein. Beispielsweise kann in Bereichen, in denen ein geringer Auftrieb oder ein geringer Vortrieb gewünscht ist, die Anzahl der Durchtrittsöffnungen verringert sein. Als Durchtrittsöffnungen kommen außerdem auch poröse Materialien wie z.B. Sintermaterialen in Frage. Hierbei sind sowohl metallische als auch bevorzugt auf Kunststoff basierende Materialien nutzbar. Diese stellen eine besonders große Zahl an statistisch verteilten Durchtrittsöffnungen geringen Querschnitts bereit, so dass in der Summe trotzdem eine große Durchflussmenge aus der Gesamtheit der Durchtrittsöffnungen ausgebbar ist. Ein weiterer Vorteil ergibt sich bei derartigen Materialien dadurch, dass die Behandlungsfläche keine ihr gegenüberliegende Fläche aufweisen muss, an welcher die Durchgangsbohrungen beginnen, sondern dass beispielsweise von den Seiten her Flüssigkeit in den porösen Block eingepresst werden kann, welche sich dann im Inneren des porösen Materials verteilt, bevor es an der Behandlungsfläche austritt. Auch besteht das die Behandlungsfläche beinhaltende Bauteil nicht mehr zwangsläufig aus mehreren Schichten, die die Zuführkanäle tragen, sondern nur noch aus einer einzigen Schicht.

Der Ablaufbereich dient zunächst der Aufnahme der Flüssigkeit, nachdem diese den flachen Gegenstand angeströmt hat. Der Ablaufbereich kann, wie bereits im Rahmen des erfindungsgemä-βen Verfahrens beschrieben, beispielsweise durch eine Überlaufkante, oder auch durch entsprechende Ablauföffnungen gekennzeichnet sein, welche nach einer bevorzugten Ausführungsform zum Teil auch innerhalb der Behandlungsfläche angeordnet sein können. Wichtig ist insbesondere, dass der Ablaufbereich so dimensioniert ist, dass er mindestens die auf die Behandlungsfläche abgegebene Flüssigkeitsmenge abführen kann, so dass ein unerwünschtes Anstauen von Flüssigkeit ausgeschlossen werden kann.

Die Überlaufkante ist bevorzugt derart ausgestaltet, dass sie einen Kantenwinkel von ≤ 90° (rechter Winkel) aufweist, wobei kleinere Winkel, die zu einer spitzeren Kante führen, bevorzugt sind. Selbstverständlich kann die Überlaufkante verschiedene Ausführungsformen derselben umfassen oder unterbrochen ausgestaltet sein.

Weitere Ausführungsformen sehen vor, dass sich in der Behandlungsfläche Nuten befinden, die bevorzugt in der Mitte der Behandlungsfläche beginnen und sich in einer Draufsicht V-förmig zu den Seiten der Behandlungsfläche bis in den oder die seitlich der Behandlungsfläche angeordneten Ablaufbereiche hin erstrecken. Der Querschnitt der einzelnen Kanäle kann dabei vorzugsweise rechteckig sein. Besonders bevorzugt liegen mehrere der Nuten parallel zueinander beabstandet. Die Spitze des "V" kann dabei sowohl in die als auch entgegen der Transportrichtung weisen. Sofern sich auch die Durchtrittsöffnungen auf bzw. in der Behandlungsfläche befinden, ist so ein besonders schneller Medienaustausch gewährleistet.

Alternativ oder zusätzlich können die Nuten auch schräg ausgebildet sein und sich über die gesamte Breite erstrecken.

Selbstverständlich sind innerhalb einer Behandlungsfläche, und auch innerhalb eines Anströmbereiches Kombinationen der genannten Ausführungsformen des Ablaufbereichs möglich.

Im Rahmen einer stationären Anlage, in welcher der flache Gegenstand gehalten und geführt, jedoch nicht vorschubmäßig bewegt werden soll, kann der Ablaufbereich bevorzugt durch eine Überlaufkante gebildet werden, die umlaufend und durchgehend oder unterbrochen ausgebildet und gewünschtenfalls Einschnitte aufweisen kann. Es ist jedoch sicherzustellen, dass im Betrieb der erfindungsgemäßen Vorrichtung jederzeit ein ausreichend hohes Flüssigkeitsniveau erreichbar ist, so dass der zu haltende und zu führende Gegenstand keinen mechanischen Kontakt zu anderen Komponenten der Vorrichtung wie insbesondere zur Behandlungsfläche bekommt. Allerdings kann es in diesem Zusammenhang vorgesehen sein, dass die Vorrichtung mechanische Zentrierhilfen oder gleichwirkende Komponenten umfasst, auf denen der Gegenstand vor der eigentlichen Behandlung abgelegt oder mit denen er gehalten und geführt wird, bis die zuvor beschriebene erfindungsgemäße Prozessierung beginnt. Ferner ist es möglich, dass der Gegenstand von einem geeigneten Mittel auf die bereits angeströmte Behandlungsfläche der erfindungsgemäßen Vorrichtung abgelegt und anschließend erfindungsgemäß behandelt oder transportiert wird.

Auch bei einem zusätzlich gewünschten Vorschub des flachen Gegenstands kann der mindestens eine Ablaufbereich als Überlaufkante oder Wehr ausgebildet sein. Bevorzugt ist dieser Bereich seitlich neben der Behandlungsfläche angeordnet, während sich der flache Gegenstand im mittleren Bereich, d.h. zwischen den beidseitigen Rändern der Behandlungsfläche entlang der gewünschten, vorgesehenen Transportbahn bewegt. Dabei ist sowohl eine Anordnung eines einzigen durchgehenden oder unterbrochen ausgestalteten Ablaufbereiches möglich, als auch die Anordnung mehrerer, besonders bevorzugt symmetrisch angeordneter Ablaufbereiche.

Wie bereits erwähnt, umfasst die erfindungsgemäße Vorrichtung zum Halten und Führen des flachen Gegenstandes keine nicht-fluidischen Kanten, Begrenzer oder sonstige mechanische Führungshilfen, und der flache Gegenstand wird im Rahmen des erfindungsgemäßen Verfahrens ausschließlich durch den Strom aus Flüssigkeit gehalten und geführt.

Im Rahmen einer bevorzugten Ausführungsform unter Verwendung eines wässrigen Flüssigkeitsfilms als Transportmittel wird Flüssigkeit kontinuierlich von unten sowie gegebenenfalls zusätzlich von oben auf die Behandlungsfläche aufgebracht bzw. durch sie mittels der Durchtrittsöffnungen abgegeben.

Durch das kontrollierte seitliche Ablaufen der Flüssigkeit, was vorzugsweise und in Analogie zur Flüssigkeitsabgabe im Anströmbereich kontinuierlich stattfindet, entsteht zwischen dem flachen Gegenstand und dem mindestens einen Ablaufbereich ein Effekt, durch den das Substrat oder der Gegenstand nicht seitlich ausbrechen und die Behandlungsfläche verlassen kann. Dieser Effekt sorgt dafür, dass der Gegenstand im Falle einer stationären Behandlung am vorgesehenen Ort verbleibt, und im Falle einer Bewegung des Gegenstandes in der vorgegebenen Transportrichtung spurgetreu auf der Behandlungsfläche geführt wird bzw. der vorgesehenen Transportbahn folgt. Der Effekt erzeugt demnach eine Kraft, die, wenn sie zusammen mit den anderen, am Gegenstand angreifenden Kräften überlagert wird, in einem Kräftegleichgewicht resultiert, welches den Gegenstand in der gewünschten Position führt. Im Übrigen wird auf die diesbezüglichen Ausführungen im Rahmen des erfindungsgemäßen Verfahrens weiter oben verwiesen.

Nach einer bevorzugten Ausführungsform ist der Anströmbereich der erfindungsgemäßen Vorrichtung als Teil der ebenen Behandlungsfläche aus einem festen oder flexiblen Material ausgebildet. Diese Fläche kann z.B. aus Kunststoff, Metall, Keramik, Holz, Stein und Verbundwerkstoffen sowie Kombinationen davon aufgebaut sein.

Nach einer Ausführungsform kann die Behandlungsfläche stationär ausgestaltet sein. Nach einer anderen Ausführungsform kann die Behandlungsfläche beweglich ausgestaltet sein, d.h. sie kann absenk- oder anhebbar, oder kippbar sein. Auf diese Weise kann je nach Bedarf eine Situation geschaffen werden, die optimal an die entsprechende Aufgabe, die Substratabmessungen, das Substratgewicht usw. angepasst ist. So kann auch die Strömung der Flüssigkeit durch entsprechende Neigung der Behandlungsfläche beeinflusst werden. Zudem kann im Rahmen von Durchlaufanlagen das temporäre Absenken und Anheben der Behandlungsfläche dazu benutzt werden, die Substrate temporär anzuhalten oder zu verlangsamen bzw. zu beschleunigen. Auch eine Selektion von z.B. beschädigtem oder gebrochenem Gut kann durch einen derartig aufgebauten "Zwei-Wege-Transport" erreicht werden.

Betrachtet man ein Substrat von 156 mm Durchmesser, so ist bevorzugt, dass auf einer Behandlungsfläche von 450 mm Länge die Menge umgesetzter, also zu- und abfließender Flüssigkeit 200 l/h beträgt. Besonders bevorzugt beträgt die Menge 400 l/h, da auf diese Weise auch ein guter Flüssigkeitsaustausch im Hinblick auf eine parallele Behandlung während des Transports gegeben ist, und zwar insbesondere auch bei Verwendung der besonders vorteilhaften vorstehend beschriebenen V-förmigen Anordnung der Nuten im Ablaufbereich.

Wesentlich für ein besonders effektives Entstehen des erfindungsgemäßen Adhäsionseffektes ist eine Anpassung der Lage des die Behandlungsfläche begrenzenden Ablaufbereiches an die Breite des Gegenstands. Für den Fall einer beispielsweise linear verlaufenden Behandlungsfläche ist demnach die Spurbreite derselben an die Breite der zu transportierenden Substrate anzupassen. Erfolgt dies nicht, ist beispielsweise der Gegenstand deutlich schmäler als die Behandlungsfläche, so wird sich der Gegenstand im Rahmen der Breite der Behandlungsfläche seitlich frei bewegen, was jedoch insbesondere im Hinblick auf eine gleichzeitige nasschemische Behandlung von Vorteil sein kann, da auf diese Weise ein besserer Austausch von Behandlungsflüssigkeit unterhalb der zu behandelnden Substratfläche stattfindet. Erst bei Erreichen des Rands der Behandlungsfläche bildet sich der erfindungsgemäße Effekt aus, der ein weiteres Abdriften des Substrates verhindert.

Nach einer bevorzugten Ausführungsform ist die Behandlungsfläche so ausgestaltet, dass sie nicht mehr als 4 mm breiter als der flache Gegenstand ist. Bevorzugt ist die Behandlungsfläche sogar nicht mehr als 3 mm breiter ausgestaltet. Ist die Behandlungsfläche hingegen schmäler als der Gegenstand, so führt dies im Rahmen der Breite der Behandlungsfläche wie oben erwähnt zu einer seitlich freien Beweglichkeit des Gegenstands. Der erfindungsgemäße Effekt bildet sich dann erst bei Erreichen des Randes der Behandlungsfläche aus.

Nach einem weiteren Aspekt betrifft die vorliegende Erfindung ein Verfahren zum Transportieren eines flachen Gegenstandes auf der Oberfläche einer strömenden Flüssigkeit, die in einen Überlaufbehälter eingespeist wird. Da die Flüssigkeit aus diesem Behälter bauartbedingt über mindestens eine Überlaufkante der seitlichen Behälterwandungen in den mindestens einen Ablaufbereich abfließt, kann der erfindungsgemäße Positioniereffekt auch bei dieser speziellen Anwendung vorteilhaft genutzt werden, so dass für das Halten und spurgetreue Führen des Gegenstandes auf der Flüssigkeit keine entsprechenden mechanischen Mittel benötigt werden. Der vom Transport allgemein umfasste Vorschub wird gewünschtenfalls ausschließlich durch die Strömungsrichtung der in den Behälter eingespeisten Flüssigkeit bereitgestellt, wobei dem Fachmann aus dem Stand der Technik zahlreiche geeignete Mittel zur Erzeugung einer gewünschten Strömungscharakteristik zur Verfügung stehen. Alternativ oder unterstützend kann die Vorschubkraft auch mittels mindestens einer erfindungsgemäßen Vorschubeinrichtung bereitgestellt werden. Somit können der erfindungsgemäße Effekt sowie die erfindungsgemäß erzielten Vorteile auch bei einem Transport eines im Wesentlichen flachen Gegenstandes durch ein mit Flüssigkeit gefülltes Becken ausgenutzt bzw. bereitgestellt werden. Die Breite des Beckens quer zur Transportrichtung entspricht im Wesentlichen der Breite des zu transportierenden Gegenstandes. Hinsichtlich weiterer Details zur Dimensionierung des Beckens als Behandlungsfläche wird insbesondere auf den vorstehenden Absatz verwiesen.

Alternativ oder zusätzlich zu dem weiter oben beschriebenen Überlaufbereich (Überlaufkante) kann der Ablaufbereich aus Bohrungen, Lochleisten, gitterartigen Öffnungen oder dergleichen bestehen oder diese umfassen, über bzw. durch die die Flüssigkeit ebenfalls von der Behandlungsfläche ablaufen kann. Ferner kann der Ablaufbereich auch aus den Anströmbereich begrenzenden Ablauflöchern ausgebildet sein. Erfindungsgemäß kommt es in allen Fällen darauf an, dass der Ablaufbereich nicht geflutet ist, sondern dass die Flüssigkeit in diesen funktionalen Bereichen eine Ablaufkante ausbildet.

Nach einer bevorzugten Ausführungsform der erfindungsgemäßen Vorrichtung umfasst diese eine aktive Absaugung der Flüssigkeit aus dem Ablaufbereich. Auf diese Weise kann insbesondere bei beengten Platzverhältnissen eine ausreichende Menge an Flüssigkeit ablaufen. Des Weiteren kann diese Menge durch eine Variation der Leistung der aktiven Absaugung gesteuert werden; beispielsweise kann es vorteilhaft sein, die Menge temporär zu begrenzen, um so einen Stau und ein damit verbundenes Anheben des Flüssigkeitsniveaus zu erreichen, oder umgekehrt so viel Flüssigkeit abzusaugen, dass vorübergehend kein erfindungsgemäßer Weitertransport des Substrats möglich ist.

Nach einer weiteren Ausführungsform, bei der zusätzlich zum Halten und Führen ein Vorschub bereitzustellen ist, umfasst die erfindungsgemäße Vorrichtung entsprechende Mittel zur Erzeugung einer auf den flachen Gegenstand wirkenden Vorschubkraft. Diese Mittel sind immer dann nötig, wenn neben dem oder anstelle des Haltens und Führens des Substrats eine (Fort-)Bewegung desselben gewünscht ist.

Der Vortrieb wird nach einer bevorzugten Ausführungsform über die aus den Durchtrittsöffnungen der Behandlungsfläche ausströmende Flüssigkeit bereitgestellt. Diese Öffnungen sind vorzugsweise als Löcher oder Schlitze ausgestaltet und können nach einer besonders bevorzugten Ausführungsform in Transportrichtung ausgerichtet sein. Ferner können Löcher oder Schlitze vorgesehen sein, deren Ausrichtung entgegen der Transportrichtung ausgelegt ist. Dem Fachmann ist daher klar, dass die Behandlungsfläche insgesamt oder auch einzelne Bereiche davon mit Löchern und/oder Schlitzen gegenläufiger Orientierung ausgestattet sein können. Ferner ist erfindungsgemäß vorgesehen, dass die Löcher oder Schlitze einzeln, in Gruppen oder auch insgesamt mit einem Flüssigkeitsstrom beaufschlagt werden können. Besonders bevorzugt ist es dabei, dass die Zusammensetzung der Gruppen während des Betriebes änderbar ist, so dass auf diese Weise eine einfache Steuerung der Vorschubkraft möglich ist.

Es ist ferner bevorzugt, dass die Durchtrittsöffnungen in ihrer Neigung und/oder ihrem Querschnitt änderbar ausgestaltet sind. Auch auf diese Weise lässt sich die Strömung gezielt zur Manipulation der Gegenstände oder zur Anpassung an deren Geometrie oder Gewicht, oder die gewünschte Transportgeschwindigkeit beeinflussen. Neben einer senkrecht zur Behandlungsfläche verlaufenden Ausrichtung der Durchtrittsöffnungen können diese demnach bevorzugt auch unter einem Winkel dergestalt ausgerichtet sein, dass die austretende Flüssigkeit eine Komponente in oder entgegen der Transportrichtung aufweist. Besonders bevorzugt ist dabei ein Neigungswinkel in Transportrichtung von 45°, woraus ein entsprechender Vorschub der Gegenstände resultiert. Ferner ist bevorzugt, dass der Neigungswinkel der Bohrungen in Richtung der Seite der Behandlungsfläche 30-45°, gemessen von der Senkrechten, beträgt.

Es kann jedoch auch vorgesehen sein, dass die Anordnung der Durchtrittsöffnungen dergestalt ist, dass ein mittels der Flüssigkeitsströmung bewegtes Substrat in Rotation versetzt wird. Hierzu sind die Durchtrittsöffnungen auf einer Kreisbahn anzuordnen, wobei sie eine Neigung tangential zu dieser Kreisbahn aufweisen. Durch Veränderung der Flüssigkeitsmenge und/oder des Neigungswinkels kann die Rotationsgeschwindigkeit beeinflusst werden.

Durch Anordnen und Ansteuern entgegengesetzt der Transportrichtung weisender Durchtrittsöffnungen kann ein Anhalten oder zumindest Verlangsamen des Substrats erzwungen werden. Auf diese Weise können temporäre Barrieren gebildet werden, die zu einer besseren Kontrolle der Verweilzeit eines Substrats an einer bestimmten Stelle ermöglichen. Durch Abschalten der entsprechenden Durchtrittsöffnungen oder durch Verschwenken derselben in Transportrichtung wird das Substrat dann wieder freigegeben.

Nach einer weiteren Ausführungsform wird die Vorschubkraft zusätzlich oder auch ausschließlich durch eine Vorschubeinrichtung bereitgestellt. Das bedeutet, dass die Vorschubkraft, die auf den Gegenstand wirkt, nicht mehr oder zumindest nicht mehr ausschließlich durch die strömende und gerichtete Flüssigkeit bereitgestellt wird. Auf diese Weise erfolgt eine zumindest teilweise Entkoppelung der Vortriebskraft von der strömenden Flüssigkeit, wodurch insbesondere eine präzisere Steuerung der entsprechenden Transportgeschwindigkeit ermöglicht wird. Dies ist insbesondere im Rahmen von Prozessierungs-Durchlaufanlagen von großer Wichtigkeit, da das Behandlungsergebnis häufig von der Behandlungszeit beeinflusst wird und genau einzuhalten ist.

Erfindungsgemäß ist es demnach möglich, sowohl ausschließlich mittels strömender Flüssigkeit, als auch ausschließlich mittels zusätzlicher Vorschubeinrichtung(en), wie auch einer Kombination beider Varianten einen Vorschub bereitzustellen.

Nach einer besonders bevorzugten Ausführungsform umfasst die Vorschubeinrichtung der erfindungsgemäßen Vorrichtung ein Antriebsmittel, welches aus der Gruppe bestehend aus Zahnriemen, Nocken, Schiebeleisten, Gliederketten, pneumatischen Zylindern, und Fluidpumpen ausgewählt ist. Ferner umfasst die Vorschubeinrichtung mindestens ein Vorschubmittel, welches aus der Gruppe bestehend aus mechanischen Anschlägen, Nocken, Rippen, Stiften, und Kratzbodenleisten ausgewählt ist. Dabei wirkt das Vorschubmittel bevorzugt jeweils nur auf die senkrecht zur Transportrichtung stehende Kante(n) des flachen Gegenstandes, und insbesondere auf die hinteren Kante. Ferner ist es besonders bevorzugt, dass das Vorschubmittel in seiner Form an die entsprechende Kante des flachen Gegenstandes angepasst ist, um so eine bestmögliche Verteilung der Vorschubkräfte zu ermöglichen.

Es kann auch vorgesehen sein, dass die Vorschubeinrichtung derart ausgestaltet ist, dass sie in Transportrichtung antreibbar und gewünschtenfalls zusätzlich anhaltbar ist. Daher können alternativ oder zusätzlich zu den oben beschriebenen Vorschubmitteln andere Mittel und Einrichtungen wie in oder entgegen der Transportrichtung ausgerichtete Luftdüsen oder in Transportrichtung antreibbare und anhaltbare sonstige Mitnehmer vorhanden sein, mit denen die Bewegung der Gegenstände abgebremst oder beschleunigt werden kann. Auch auf diese Weise kann die Relativgeschwindigkeit zwischen der Flüssigkeit und dem zu transportierenden Gegenstand jederzeit den Erfordernissen angepasst werden.

Im Folgenden sollen einige besonders bevorzugte Ausführungsformen einer Vorschubeinrichtung mit mindestens einem Mitnehmer detailliert beschrieben werden.

Nach einer ersten Ausführungsform ist die Vorschubeinrichtung einschließlich ihres wenigstens einen Mitnehmers oberhalb der Behandlungsebene angeordnet, und der oder die Mitnehmer sind derart ausgestaltet, dass mit ihrem jeweiligen Ende die Kante eines zu behandelnden Substrates berührt werden kann. Im Rahmen dieser Ausführungsform kann die Vorschubeinrichtung als separate bauliche Komponente oder als integraler Bestandteil einer ggf. oberhalb der Behandlungsfläche vorhandenen weiteren Behandlungsfläche zur Ausbildung eines oberen Fluidkissens ausgestaltet sein. Sofern die Vorschubeinrichtung als separate bauliche Komponente dargestellt ist, weist die weitere Behandlungsfläche vorzugsweise Aussparungen für den wenigstens einen Mitnehmer auf, damit dieser die Substratkante während ihres Transportes entlang des Segmentes dauerhaft berühren kann.

Nach einer zweiten Ausführungsform ist die Vorschubeinrichtung einschließlich ihres wenigstens einen Mitnehmers unterhalb der Behandlungsebene als integraler Bestandteil der Behandlungsfläche zur Ausbildung des unteren Fluidkissens angeordnet.

Nach einer dritten Ausführungsform ist die Vorschubeinrichtung einschließlich ihres wenigstens einen Mitnehmers parallel zur Vorschubrichtung seitlich der Behandlungsebene als integraler Bestandteil der seitlichen Wandung einer ggf. vorhandenen Behandlungskammer angeordnet.

Für den Fachmann ist klar, dass diese grundsätzlichen Ausgestaltungen erfindungsgemäß in Abhängigkeit des konkreten Anwendungsgebietes miteinander kombiniert werden können.

Weiterhin gilt erfindungsgemäß, dass die obigen Ausführungsformen jeweils nicht nur mit einer einzigen, sondern bevorzugt mit zwei Vorschubeinrichtungen realisiert werden können, die am meisten bevorzugt baugleich ausgestaltet sind.

Im Rahmen der obigen ersten Ausführungsform ist die Vorschubeinrichtung als separate bauliche Komponente daher vorzugsweise zweiteilig ausgeführt, wobei jeder Teil wenigstens einen Mitnehmer aufweist. Die Mehrteiligkeit ist insbesondere dann erforderlich oder vorteilhaft, wenn mehrere Segmente hintereinander geschaltet werden und die Segmente jeweils eine gewisse Mindestlänge überschreiten. Auch wenn bereits das nächste Substrat in den Bereich eines Segmentes eingeführt werden soll, solange sich das vorherige Substrat noch teilweise auf diesem Segment befindet, ist eine mehr- wie insbesondere zweiteilige Vorschubeinrichtung notwendig. Die mehrteilige Ausgestaltung der Vorschubeinrichtung bedeutet, dass sie aus mindestens zwei Baugruppen besteht, die im Wesentlichen identische Aufgaben erfüllen und daher einen im Wesentlichen identischen Aufbau haben. Wesentlichster Unterschied der Teile zueinander ist deren Positionierung im Bereich eines Segmentes. Gewöhnlich wird vorgesehen sein, dass ein Teil einer mehrteiligen Vorschubeinrichtung im Eingangsbereich des Segments angeordnet ist, während sich ein weiterer Teil im Ausgangsbereich des Segments befindet. Dementsprechend wird der eine Teil eher für den Vorschub des Substrats im Eingangsbereich, der andere Teil für den Vorschub im Ausgangsbereich eingesetzt werden. Für den Fall, dass ein Segment mehrere Behandlungsebenen bzw. Behandlungsspuren umfasst, können für jede dieser Behandlungsspuren eine oder mehrere individuelle Vorschubeinrichtungen vorgesehen sein. Es ist jedoch bevorzugt, die Teile der Vorschubeinrichtungen soweit als möglich zusammenzufassen, was immer dann leicht möglich ist, wenn auf parallelen Spuren synchronisiert behandelt und transportiert werden soll.

Alternativ umfasst die obige erste Ausführungsform eine einteilige Vorschubeinrichtung als separate bauliche Komponente, welche in Bezug auf die Länge der Behandlungsebene eines Segmentes bevorzugt in etwa in der Mitte desselben angeordnet ist. Damit ein fortdauernder Kontakt des oder der Mitnehmer an der Substratkante gewährleistet ist, sind diese bevorzugt teleskopierbar ausgestaltet. Auf diese Weise ist sichergestellt, dass die Mitnehmer die Substratkante immer in Höhe der Behandlungsebene kontaktieren können.

Erfindungsgemäß umfasst jedes Teil einer mehrteiligen Vorschubeinrichtung Mitnehmer. Nur die Mitnehmer stehen dabei erfindungsgemäß in unmittelbarem Kontakt mit dem Substrat.

Im Rahmen der obigen ersten und zweiten Ausführungsform ist die Vorschubeinrichtung als integraler Bestandteil der unteren bzw. oberen Behandlungsfläche vorzugsweise mehr- wie insbesondere zweiteilig ausgestaltet, wobei jedes Teil zwei Mitnehmer umfasst, die parallel zueinander und vorzugsweise in einem bestimmten Abstand voneinander angeordnet sind. Auch hier gilt, dass der eine Teil eher am Eingang und der andere Teil eher am Ausgang des Segments angeordnet sind. Die jeweiligen Mitnehmer der Teile können aus den Behandlungsflächen ausgefahren werden und berühren dann die Substratkante, was vorzugsweise synchronisiert erfolgt. Nach bestimmungsgemäß erfolgtem Vorschub können die Mitnehmer wieder in die jeweilige Behandlungsfläche eingefahren werden.

Im Rahmen der obigen dritten Ausführungsform ist die Vorschubeinrichtung als integraler Bestandteil der seitlichen Wandungen einer ggf. vorhandenen Behandlungskammer und damit zweiteilig (beidseitig) ausgestaltet. Wie zuvor erläutert, können die Mitnehmer seitlich aus der jeweiligen Wandung ausgefahren werden, damit sie die Substratkante berühren, was ebenfalls bevorzugt synchronisiert erfolgt.

Erfindungsgemäß ist bevorzugt vorgesehen, dass die in die jeweilige Vorschubrichtung weisende Geschwindigkeit des Vorschubes derart einstellbar ist, dass sie im Zusammenwirken mit der Strömungsgeschwindigkeit des Fluidkissens dazu führt, dass das Substrat ständig gegen den oder die Mitnehmer der Vorschubeinrichtung gedrückt wird und auf diese Weise vermieden wird, dass sich das Substrat unkontrolliert von dem Mitnehmer oder den Mitnehmern entfernt.

Für den Fall der Bereitstellung eines oberen Fluidkissens kann in Abhängigkeit der konkreten Ausgestaltung der Vorschubeinrichtung vorzugsweise vorgesehen sein, dass die das obere Fluidkissen erzeugende weitere Behandlungsfläche Aussparungen für den wenigstens einen Mitnehmer aufweist. Diese Aussparungen sind von den Flüssigkeit ausgebenden Austrittsöffnungen funktionell entkoppelt und dienen dazu, dass ein von oben operierender Mitnehmer während seines Weges in Vorschubrichtung stets zuverlässig die Kante eines Substrates kontaktieren kann. Im Falle des Vorhandenseins einer mehr- d.h. beispielsweise zweiteiligen Vorschubeinrichtung würde die obere Behandlungsfläche entsprechend mehrere wie z.B. zwei Aussparungen aufweisen.

Die Anzahl an Aussparungen in der oder den Behandlungsflächen entspricht gewöhnlich der Anzahl der Teile einer erfindungsgemäßen Vorschubeinrichtung sowie der jeweiligen Anzahl der Mitnehmer eines Teils. Die Aussparungen verlaufen entsprechend den von dem oder den Mitnehmern auszuführenden Bewegungen und sind im Falle mindestens zweier Mitnehmer pro Teil im Wesentlichen parallel zueinander angeordnet. Erfindungsgemäß ist das Vorhandensein von lediglich einem Mitnehmer pro Teil bereits ausreichend, da das sichere Führen und Halten eines Gegenstandes bereits durch die oben beschriebene Vorgehensweise erreicht wird. Nach einer im Falle von mehr als einem Mitnehmer pro Teil bevorzugten Ausführungsform sind die Aussparungen für jeweils einen Teil einer mehr- wie insbesondere zweiteiligen Vorschubeinrichtung mit mindestens zwei Mitnehmern quer zur Transportrichtung voneinander beabstandet, wobei der jeweilige Abstand im Falle einer zweiteiligen Vorschubeinrichtung besonders bevorzugt derart unterschiedlich ist, dass eine Berührung der Mitnehmer unterschiedlicher Teile ausgeschlossen ist. Dies ist insbesondere dann erforderlich, wenn ein Substrat von den Mitnehmern eines ersten Teils an die Mitnehmer eines weiteren Teils einer mehr- wie insbesondere zweiteilige Vorschubeinrichtung übergeben werden soll. Entsprechend sind die Aussparungen für die Mitnehmer einer mehr- wie insbesondere zweiteiligen Vorschubeinrichtung in der oder den Behandlungsflächen derart angeordnet, dass eine Berührung der Mitnehmer unterschiedlicher, aber zusammenwirkender Teile ausgeschlossen ist.

Jedes Teil der Vorschubeinrichtung ist aufgrund seiner Mitnehmeranordnung daher geeignet, das Substrat vorzugsweise an seiner hinteren bzw. in seinem hinteren Bereich liegenden Kante zu berühren und in Vorschubrichtung zu bewegen. Besonders bevorzugt greift diese Berührung symmetrisch wie insbesondere mittig am Substrat an, ein Vorschub ist jedoch auch mittels asymmetrischen Kraftangriffs zu realisieren, sofern die aus der Asymmetrie resultierende Rotationskomponente nicht so groß wird, dass der erfindungsgemäße Positioniereffekt überwunden wird. Aus der Sicht des Substrats gesehen wirkt daher bevorzugt jederzeit eine schiebende Kraft auf dasselbe, wohingegen aus Sicht der einzelnen Teile einer mehrteiligen Vorschubeinrichtung auch eine ziehende Bewegung denkbar ist, nämlich insbesondere dann, wenn ein im Bereich des Ausgangs angeordneter Teil der Vorschubeinrichtung ein Substrat an dessen Hinterseite kontaktiert, welches sich noch im mittleren Bereich des Segmentes befindet. Trotzdem sind die auf das Substrat wirkenden Kräfte ausschließlich Druckkräfte.

Besonders bevorzugt sind die Mitnehmer stabförmig ausgebildet und weisen kugel- oder kugelsegmentähnliche Berührflächen auf, so dass nach Möglichkeit nur eine Punkt-, oder Linienberührung, nicht jedoch eine Flächenberührung zwischen Mitnehmer und Substratkante auftritt. Zudem ist vorgesehen, dass die Mitnehmer eines Teils an einer gemeinsamen Kinematik angeordnet sind, mit welcher im Rahmen der Substratberührung die Positionierung der Berührflächen in Bezug zur Substratkante während der Behandlung jederzeit sicher einstellbar ist. Mit anderen Worten muss die Kinematik dazu geeignet sein, dass die Berührflächen immer in der richtigen Höhe in Bezug auf die Behandlungsebene angeordnet sind. Dazu können bevorzugt die aus dem Stand der Technik bekannten Kulissen- oder Gelenksteuerungen Verwendung finden. Besonders effektiv kann diese Aufgabe mittels einer parallelogrammartigen Kinematik gelöst werden. Aber auch Linearvorschübe oder robotergeführte Vorrichtungen sind prinzipiell zur Erfüllung dieses Zwecks geeignet, wenn auch aus Kosten- und Komplexitätsgründen weniger bevorzugt.

Die vorstehende Beschreibung stützte sich beispielhaft auf den Transport entlang eines Segmentes. Es ist klar, dass mit einer derartigen Vorschubeinrichtung auch andere Längenabschnitte überbrückt werden können. Besonders vorteilhaft wird eine solche Vorschubeinrichtung daher innerhalb von Behandlungsanlagen eingesetzt.

Eine weitere bevorzugte Ausführungsform sieht vor, dass die Gegenstände innerhalb diskreter Abschnitte oder Segmente der Vorrichtung transportiert werden, wobei an den Segmentgrenzen Einrichtungen zum Anhalten oder Abbremsen des flachen Gegenstandes angeordnet sind. Beispielsweise können diese Abschnitte jeweils durch gewünschtenfalls schließbare Einrichtungen wie z.B. schließbare Ablaufrinnen, absenkbare Überlaufkanten, oder absenkbare und/oder schließbare Lochleisten voneinander getrennt sein. Es kann dabei sowohl vorgesehen sein, dass nur die mindestens eine Behandlungsfläche, oder der mindestens eine Ablaufbereich, oder dass beide Bereiche in einzelne Segmente mit entsprechenden Segmentgrenzen unterteilbar sind.

Ferner kann auch vorgesehen sein, dass die genannten Segmentgrenzen durch gasförmiges Fluid gebildet werden, sofern der Gegenstand mehrere getrennte Nassbereiche mit unterschiedlichen, voneinander zu trennenden Flüssigkeiten passieren soll. Auf diese Weise kann ein Überfließen flüssigen Mediums von einem Segment zum nächsten verhindert werden, wohingegen die zu transportierenden Gegenstände dieses Medienwehr auf dem Flüssigkeitspolster überqueren können. Vorzugsweise weisen diese gasförmigen Fluidkissen in Transportrichtung eine Länge auf, die kleiner als die Substratlänge ist, sodass die Führung mittels Flüssigkeit gewährleistet bleibt.

Der oben beschriebene Effekt zum Halten oder Führen kann demnach ebenfalls zur kontrollierten Beabstandung der zu transportierenden Gegenstände genutzt werden. Wenn aus Effizienzgründen mehrere Substrate in möglichst geringem Abstand nacheinander in einer Spur durch eine bzw. zwischen mehreren Anlagen befördert werden sollen, ist es wichtig sicherzustellen, dass die Substrate nicht aneinander anstoßen und so gegenseitige Beschädigungen hervorrufen.

Ferner kann diese Ausgestaltung auch für einen schrittweisen Transport verwendet werden, um stationäre Behandlungszeiten zu ermöglichen. Dazu ist es vorteilhaft, wenn die Vorrichtung entsprechende Sensoren umfasst, welche den Abstand zwischen aufeinander folgenden Substraten erfassen und an eine geeignete Steuerung weiterleiten, welche ihrerseits die Einrichtungen zum Anhalten und/oder die Antriebsmittel der Vorschubeinrichtung in geeigneter Weise steuert.

Nach dieser Ausführungsform kann die Strömungsbeeinflussung beispielsweise durch temporäres Fluten der ggf. vorhandenen Ablaufrinnen erfolgen, indem beispielsweise das Fördervolumen entsprechend erhöht, oder der Abfluss der entsprechenden Rinne verkleinert oder ganz verschlossen wird. Auf diese Weise entfällt der Widerstand für das Substrat in Transportrichtung und das Transportgut wird wieder beschleunigt.

Ferner ist es bevorzugt, dass über die Behandlungsfläche Ultraschall im kHz- oder Megahertzbereich in die Flüssigkeit eingekoppelt werden kann. Dazu umfasst die erfindungsgemäße Vorrichtung optional entsprechende Ultra- und/oder Megaschallstrahler. Diese können so angeordnet sein, dass der Schall auf direktem Wege zu den flachen Gegenständen gelangt, oder sie können so angeordnet sein, dass eine indirekte Beschallung der flachen Gegenstände erfolgt, beispielsweise durch eine Anregung der Seitenwände eines ggf. vorhandenen Flüssigkeitsbeckens, oder mittels Reflexion.

Nach einer weiteren Ausführungsform ist erfindungsgemäß ebenfalls vorgesehen, dass die strömende Flüssigkeit nicht nur unterhalb des flachen Gegenstandes, sondern auch oberhalb desselben bereitgestellt wird, so dass die Vorrichtung einen sandwichartigen Aufbau aufweist. Dementsprechend weist die erfindungsgemäße Vorrichtung auch zwei Behandlungsfläche n auf, wobei es aufgrund der Schwerkraft ausreichen kann, lediglich einen untenliegenden Ablaufbereich vorzusehen.

Schließlich ist es bevorzugt, dass die Vorrichtung ferner mindestens eine Einrichtung zur Strömungskontrolle umfasst, mit welcher die Strömungsgeschwindigkeit der Transport- bzw. Behandlungsflüssigkeit durch lokale und/oder globale Änderung der Einströmmenge und/oder der Einströmgeschwindigkeit und/oder der Ausströmmenge und/oder der Ausströmgeschwindigkeit und/oder der Absaugung und/oder der Höhe des Flüssigkeitsfilms beeinflussbar ist.

Die Erfindung wird anhand der beigefügten Zeichnungen näher erläutert.

### Figurenübersicht

Figur 1 zeigt eine bevorzugte Ausführungsform der Behandlungsfläche der erfindungsgemäßen Vorrichtung in einer Draufsicht.
Figur 2 zeigt die erfindungsgemäße Vorrichtung mit einer ersten Ausführungsform der erfindungsgemäß vorgesehenen Vorschubeinrichtung.
Figur 3 zeigt die erfindungsgemäße Vorrichtung mit einer zweiten Ausführungsform der erfindungsgemäß vorgesehenen Vorschubeinrichtung.
Figur 4 zeigt die erfindungsgemäße Vorrichtung mit verschiedenen Ausführungsformen der erfindungsgemäß vorgesehenen Vorschubeinrichtung in einer Frontalsicht.
Figur 5 zeigt zwei parallel verlaufende, mit Substraten beladene Behandlungsflächen der erfindungsgemäßen Vorrichtung in einer perspektivischen Ansicht.
Figur 6 zeigt zwei parallel verlaufende, mit Substraten beladene und einseitig segmentierte Behandlungsflächen der erfindungsgemäßen Vorrichtung in einer perspektivischen Ansicht.
Figur 7 zeigt eine weitere Ausführungsform zwei parallel verlaufender, mit Substraten beladener Behandlungsflächen der erfindungsgemäßen Vorrichtung in einer perspektivischen Ansicht.
Figur 8 zeigt eine Draufsicht (Fig. 8A) auf eine bevorzugte Ausführungsform der erfindungsgemäßen Vorrichtung, sowie deren Schnittansicht (Fig. 8B).
Die Figur 9 zeigt eine Schnittansicht einer weiteren Ausführungsform der erfindungsgemäßen Vorrichtung.
Die Figur 10 zeigt eine bevorzugte Ausführungsform einer Einrichtung zum Anhalten des Substrats.
Figuren 11A und 11B zeigen eine Übersicht zur Situation im Randbereich der Behandlungsfläche bzw. ein Detail derselben.
Figur 12 zeigt die Schnittansicht einer Ausführungsform der erfindungsgemäßen Vorrichtung mit zwei Flüssigkeit F ausgebenden Behandlungsflächen 7 gezeigt, von denen eine unterhalb und eine weitere oberhalb des Substrats 1 angeordnet ist.

### Figurenbeschreibung

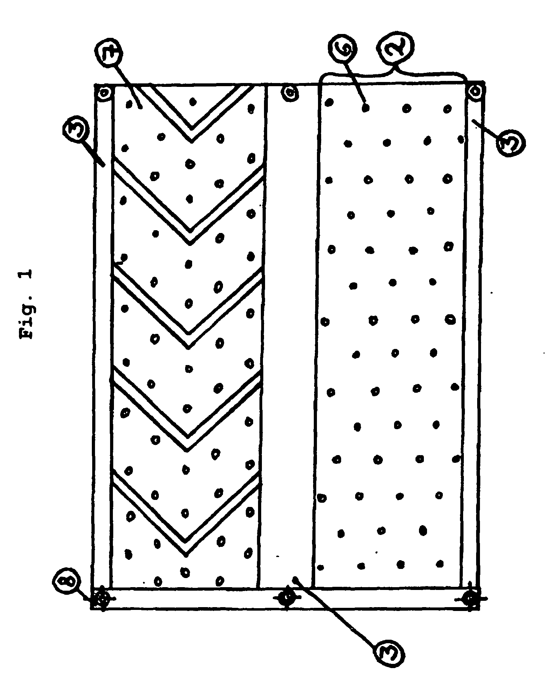

Die Figur 1 zeigt eine bevorzugte Ausführungsform der Behandlungsfläche der erfindungsgemäßen Vorrichtung mit angrenzenden Ablaufbereichen in einer Draufsicht. Die Behandlungsfläche 7 umfasst einen Anströmbereich 2, der in der dargestellten Ausführungsform mittig auf der Behandlungsfläche 7 angeordnet ist, und wird von zwei beidseitig angeordneten Ablaufbereichen 3 begrenzt. Der Anströmbereich 2 umfasst eine Vielzahl von Durchtrittsöffnungen 6, welche in der dargestellten Ausführungsform regelmäßig angeordnet sind. Ferner sind kleine Bohrungen als Zuläufe dargestellt.

Die Figur 1 deutet auch an, dass die erfindungsgemäße Vorrichtung aus einzelnen Segmenten zusammengesetzt sein kann, die jeweils wie in der Figur 1 gezeigt ausgeführt sind und hintereinander angeordnet werden können. Dazu ist vorteilhafterweise ein Überlappbereich 8 vorgesehen, der so ausgestaltet ist, dass ein Ende des Segments gerade den Anfang des nächsten Segmentes überlappt. Dazu ist der Überlappbereich an einem Ende als Negativ des Überlapps des anderen Endes ausgeformt.

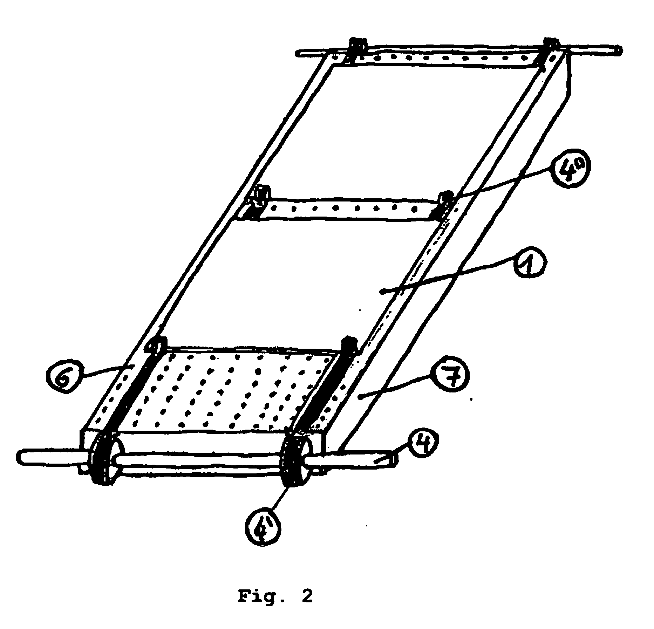

In der Figur 2 ist eine Ausführungsform der erfindungsgemäßen Vorrichtung gezeigt, nach welcher sie eine erste Ausführungsform der erfindungsgemäß vorgesehenen Vorschubeinrichtung 4 umfasst. Diese umfasst als Rollen und Bänder ausgebildete Antriebsmittel 4', an denen Vorschubmittel 4" in Form von Mitnehmer angebracht sind, die als Plättchen ausgestaltet sind. Die Plättchen berühren die Substrate 1 lediglich an der von der Transportrichtung T weg weisenden Hinterkante.

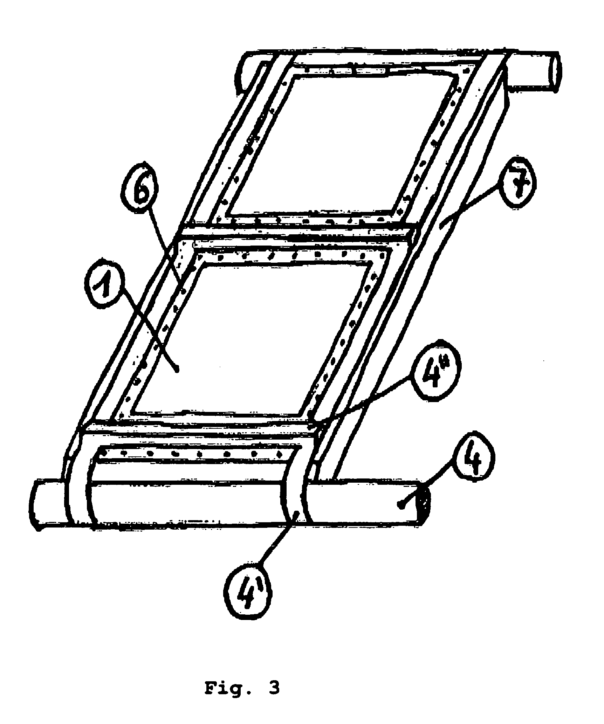

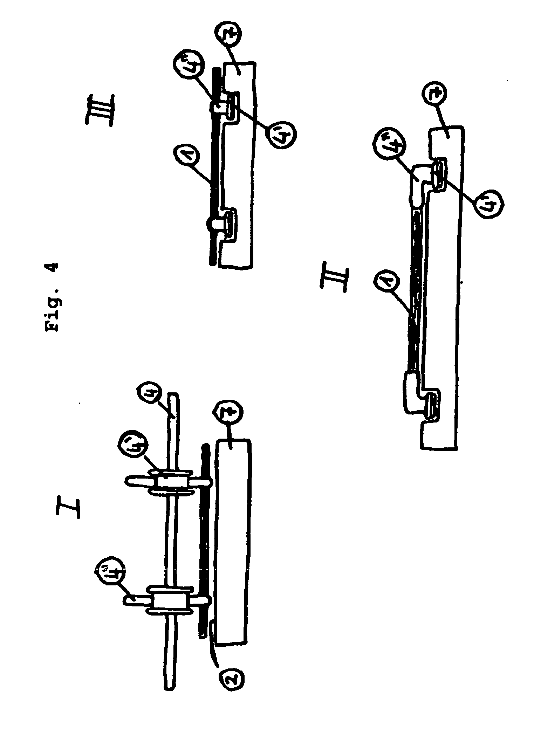

Die Figur 3 zeigt eine zweite Ausführungsform der erfindungsgemäß vorgesehenen Vorschubeinrichtung mit Kratzbodenleisten. Dabei sind die leistenartigen Mitnehmer durchgehend ausgebildet, so dass sie die gesamte Hinterkante der jeweiligen Substrate 1 kontaktieren. Die Unterseite der Leisten schleift dabei auf der Behandlungsfläche. Die einzelnen Kratzbodenleisten sind voneinander beabstandet und jeweils beidseitig mit entsprechenden Antriebsriemen verbunden.Die Figur 4 zeigt die erfindungsgemäße Vorrichtung mit verschiedenen Ausführungsformen der erfindungsgemäß vorgesehenen Vorschubeinrichtung jeweils in einer Frontalsicht.

Die mit "I" bezeichnete Darstellung zeigt oberhalb des Anströmbereichs 2 und des Substrats 1 angeordnete Vorschubmittel 4". Die Mitnehmer weisen dementsprechend nach unten, wo sie die Hinterkante des Substrats 1 berühren und auf dieses eine Vorschubkraft V ausüben, welche in der Darstellung in die Zeichenebene hinein weist.

Die mit "II" bezeichnete Darstellung zeigt Vorschubmittel 4", welche unterhalb des Substrats 1 angeordnet sind. In der dargestellten Ausführungsform verlaufen die Antriebsmittel 4' in Vertiefungen, die den Anströmbereich entlang der Transportrichtung T durchziehen. An diesen sind die Vorschubmittel 4" derart befestigt, dass sie nach oben in den Transportbereich des Substrats hineinragen und dort dessen Hinterkante berühren.

In der mit "III" bezeichneten Darstellung sind die als Mitnehmer ausgebildeten Vorschubmittel 4" abgewinkelt ausgebildet, so dass sie die hinteren Ecken und einen Teil der hinteren Kante des jeweiligen Substrats 1 berühren.

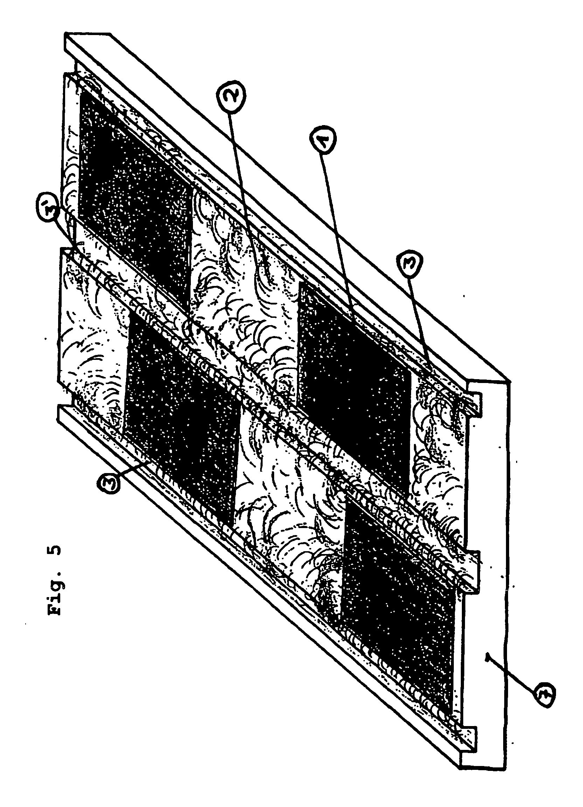

Die Figur 5 zeigt zwei parallel verlaufende, mit Substraten 1 beladene Behandlungsflächen 7 der erfindungsgemäßen Vorrichtung in einer perspektivischen Ansicht. Die in der Figur gezeigten Flüssigkeits-Wellen deuten die auf dem Anströmbereich 2 befindliche und von diesem in den Ablaufbereich 3, genauer in mehrere Ablaufrinnen 3', ablaufende Flüssigkeit F an. Vorteilhafterweise dient die mittig angeordnete Ablaufrinne 3' gleichzeitig als Ablaufrinne für beide Behandlungsflächen 7. Nicht dargestellt sind Bohrungen, die die in den Ablaufrinnen gesammelte Flüssigkeit aus ihnen abführen.

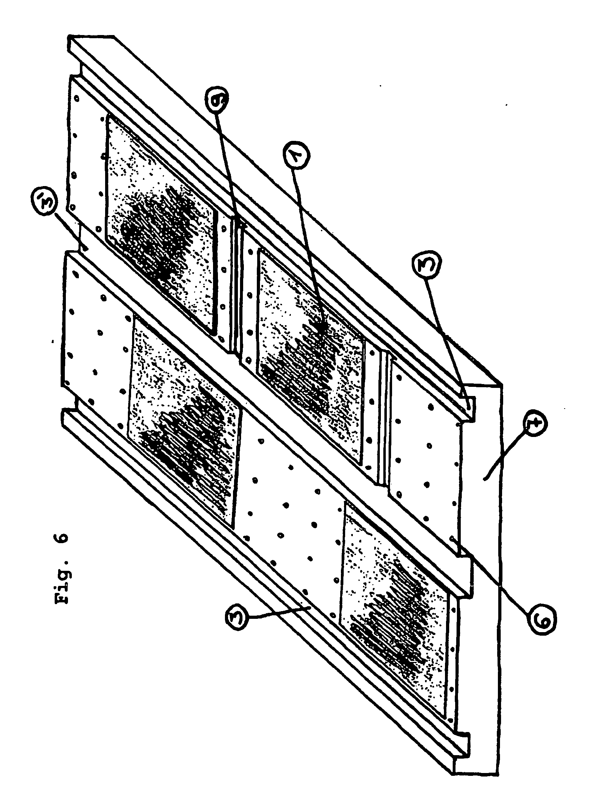

In der Figur 6 sind zwei parallel verlaufende, mit Substraten beladene und einseitig segmentierte Behandlungsflächen 7 der erfindungsgemäßen Vorrichtung in einer perspektivischen Ansicht gezeigt. Die Segmente der rechts dargestellten Behandlungsfläche werden durch Segmentgrenzen 9 voneinander abgetrennt. Diese Segmentgrenzen 9 sind nach der dargestellten Ausführungsform als Ablaufrinnen 3' ausgebildet. Sofern die Menge der aus den Durchtrittsöffnungen 6 ausströmenden Flüssigkeit F (nicht dargestellt) zu gering ist, können die Substrate 1 die Segmentgrenzen 9 nicht überwinden. Sobald die Menge der Flüssigkeit entsprechend erhöht und somit das Flüssigkeitsniveau angehoben wird, können die Substrate 1 die Segmentgrenzen 9 passieren. Alternativ können die Segmentgrenzen auch verschließbare Ablauföffnungen aufweisen, die bei Verschluss die Ablaufrinnen 3' volllaufen lassen, so dass die Substrate 1 die Segmentgrenzen 9 passieren können.

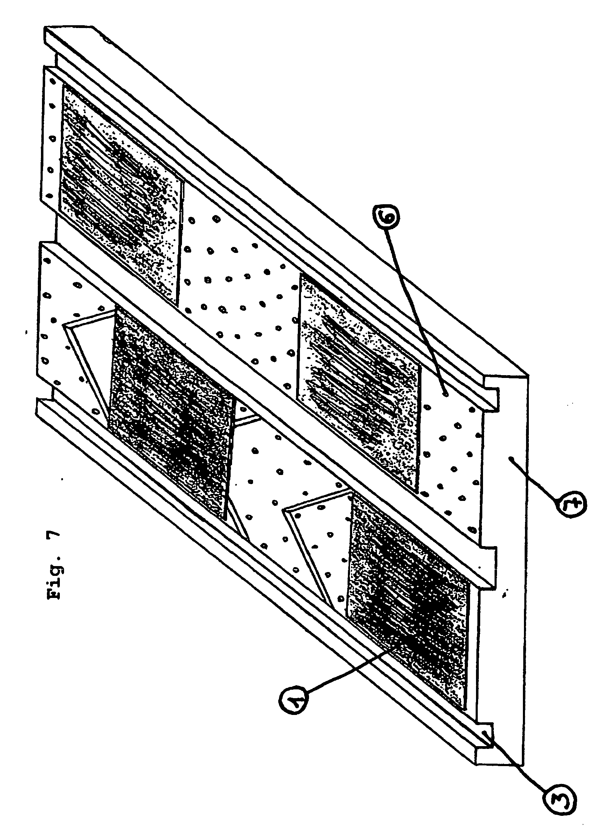

Die Figur 7 zeigt eine weitere Ausführungsform zwei parallel verlaufender, mit Substraten 1 beladener Behandlungsflächen 7 der erfindungsgemäßen Vorrichtung in einer perspektivischen Ansicht. Die hier dargestellte Ausführungsform entspricht im Wesentlichen der in der Figur 1 als Draufsicht dargestellten Ausführungsform, wobei die links im Bild befindliche Behandlungsfläche die bevorzugte Ausführungsform mit V-förmigen Nuten darstellt.

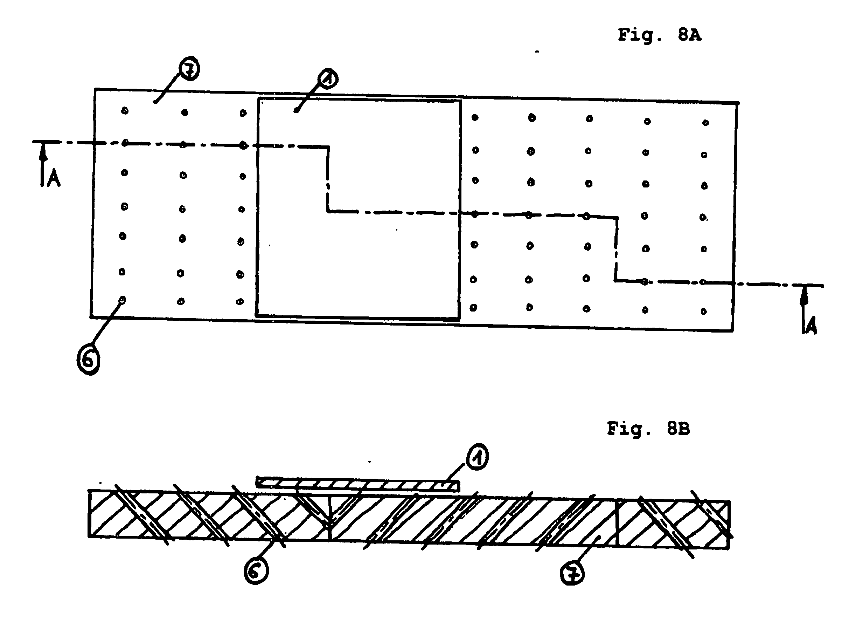

Die Figur 8 zeigt eine Draufsicht (Fig. 8A) auf eine bevorzugte Ausführungsform der erfindungsgemäßen Vorrichtung mit einem Substrat 1. Auf der Behandlungsfläche 7 befinden sich mehrere Reihen von Durchtrittsöffnungen 6, die mit einem darunter liegenden, nicht dargestellten Zu- bzw. Abführsystem verbunden sind. Ebenfalls dargestellt ist eine Schnittlinie, deren zugehörige Seitenansicht in der Fig. 8B gezeigt ist. Gut zu erkennen sind die geneigten Durchtrittsöffnungen 6, welche teilweise in die nach rechts weisende Transportrichtung T, und teilweise entgegen derselben geneigt sind. Auch ersichtlich ist, dass auch auf ein und derselben Reihe von Durchtrittsöffnungen 6, also in jeweils gleichem Abstand zur Seite der Behandlungsfläche 7, unterschiedliche Neigungen vorgesehen sind. Dementsprechend können diese Durchtrittsöffnungen 6, sofern sie in Gruppen ansteuerbar sind, wahlweise zum Beschleunigen oder zum Abbremsen eines Substrates verwendet werden. Ferner ist vorgesehen, dass die Vorrichtung insgesamt um einen Winkel 10 gekippt werden kann, um so gewünschtenfalls und in Abhängigkeit der Neigungsrichtung eine zusätzliche Beschleunigungs- oder Verzögerungskraft auf das Substrat auszuüben.

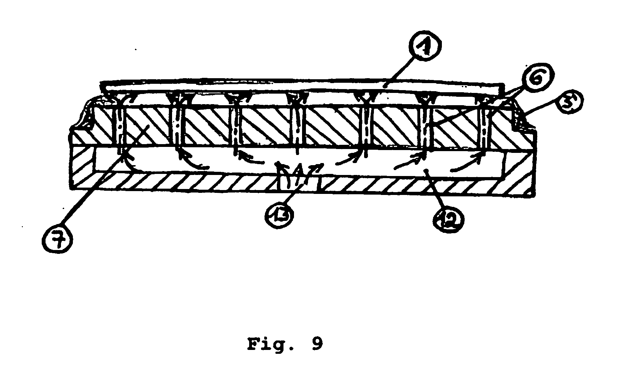

Die Figur 9 zeigt eine Schnittansicht durch die erfindungsgemäße Vorrichtung, entlang einer senkrecht auf der Transportrichtung T stehenden Ebene. Auf der Behandlungsfläche 7 ist das Substrat 1 abgelegt. Durch Durchtrittsöffnungen 6 tritt Flüssigkeit F auf die Behandlungsfläche 7 aus und bildet einen Flüssigkeitsfilm, der das Substrat 1 trägt. Unterhalb der Durchtrittsöffnungen 6 ist ein Hohlraum 12 mit einem Einlass 13 vorhanden, welcher die einzelnen Durchtrittsöffnungen 6 mit Flüssigkeit speist. Diese verlässt die Behandlungsfläche 7 seitlich in entsprechende Ablaufrinnen 3'.

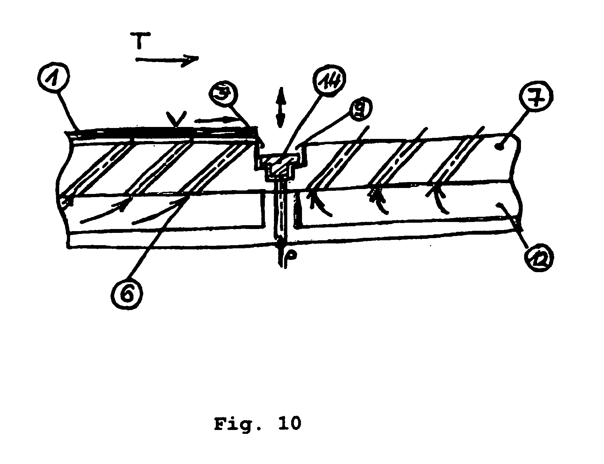

In der Figur 10 ist eine bevorzugte Ausführungsform einer Einrichtung zum Anhalten des Substrats gezeigt. Die Figur ist als weitere Schnittansicht dargestellt, die nunmehr entlang einer Ebene verläuft, welche parallel zur Transportrichtung T und senkrecht zur Oberfläche der Behandlungsfläche 7 steht. Im linken Bildteil ist ferner ein Substrat 1 gezeigt, welches in unmittelbarer Nähe zu einer Segmentgrenze 9 zweier aufeinander folgender Segmente steht. Aufgrund der in Transportrichtung T geneigten Durchtrittsöffnungen 6 übt Flüssigkeit, welche durch den Hohlraum 12 in die Durchtrittsöffnungen 6 und weiter auf die Behandlungsfläche 7 strömt, eine Vorschubkraft V auf das Substrat 1 aus. Allerdings ist an der Segmentgrenze 9 eine Vertiefung in Form einer Ablaufrinne 3' vorhanden, in welche die Flüssigkeit F bevorzugt abfließt, so dass das Substrat 1 diese Vertiefung nicht überwindet. Wird allerdings die vertikal bewegliche Leiste 14 bis auf das Niveau der Behandlungsfläche 7 angehoben, was beispielsweise durch einen Überdruck auf die Unterseite der Leiste 14 geschehen kann, so schließt sich die Ablaufrinne 3', und das Substrat 1 kann passieren.

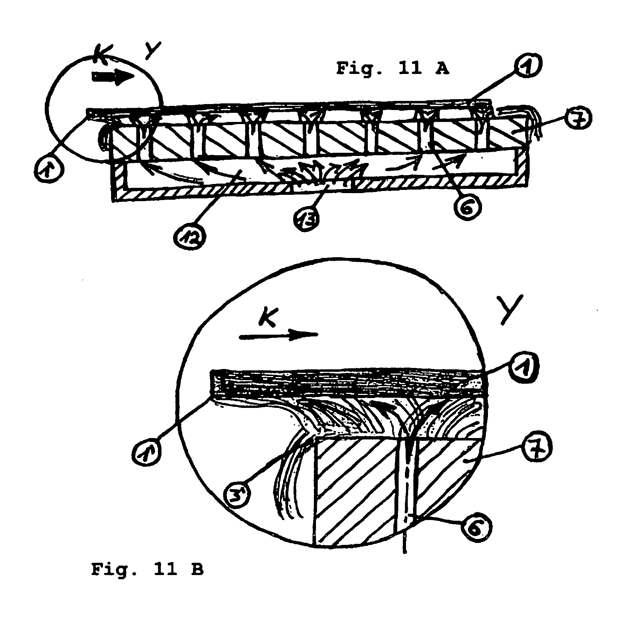

Die Figuren 11A und 11B zeigen eine Übersicht zur Situation im Randbereich der Behandlungsfläche bzw. ein Detail Y derselben. Gezeigt ist jeweils ein Substrat 1, welches sich auf der Behandlungsfläche 7 befindet und so positioniert ist, dass es etwas über den Rand der Behandlungsfläche 7 hinaus- und in den Bereich der Ablaufrinne 3' hineinragt. Das Substrat wird wiederum durch von unten ihm entgegen strömende Flüssigkeit angehoben. Im Randbereich strömt die Flüssigkeit vornehmlich in die Ablaufrinne 3', benetzt aber auch weiterhin die Unterseite des Substrats 1. Die Oberflächenspannung dieses die Unterseite benetzenden dünnen Flüssigkeitsfilms sucht, die freie Oberfläche zu verringern, um so einen energetisch günstigeren Zustand einzunehmen. Solange die Substratkante 1' nicht zu weit über den Rand der Behandlungsfläche 7 hinausragt, reicht der besagte Flüssigkeitsfilm bis zur Substratkante 1', die er jedoch nicht in Richtung der Oberseite des Substrats 1 überwinden kann. Aufgrund des an dieser gewöhnlich scharfen Kante sich ausbildenden Kapillareffektes, welcher den Rand des Flüssigkeitsfilms auf der Kante des Substrats fixiert, kann der Flüssigkeitsfilm seine Oberfläche nur verkleinern, indem er das Substrat 1 in Richtung der Behandlungsfläche 7 zieht (Führungskraft K) und so den erfindungsgemäß gewünschten Effekt der Selbstpositionierung herbeiführt.

Für den Fall eines Transports mit Behandlungsflüssigkeit ist demnach bei korrekt eingestellten Geometrie- und Strömungsparametern eine ausschließlich einseitige Behandlung des Substrats erreichbar, wobei die Kanten ggf. mit benetzt werden.

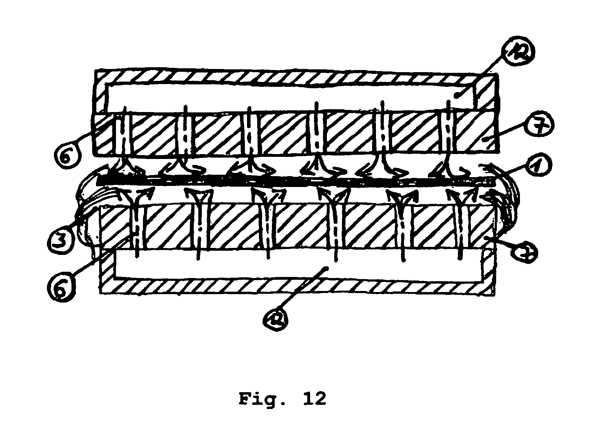

In der Figur 12 ist die Schnittansicht einer Ausführungsform der erfindungsgemäßen Vorrichtung mit zwei Flüssigkeit F ausgebenden Behandlungsflächen 7 gezeigt, von denen eine unterhalb und eine weitere oberhalb des Substrats 1 angeordnet ist. Wiederum werden die Durchtrittsöffnungen 6 über entsprechende Hohlräume 12 gemeinsam mit Flüssigkeit F versorgt, welches gegen beide Seiten des Substrats 1 strömt, so dass dieses nunmehr beidseitig gehalten wird. Neben der Behandlungsfläche 7 befinden sich beidseitig angeordnete Ablaufbereiche 3, in welche die Flüssigkeit nach dem Verlassen des Transportspalts abfließen kann.

Die Erfindung ermöglicht das Halten und Führen von im Wesentlichen flachen Gegenständen durch ausschließliche Verwendung einer bevorzugt strömenden Flüssigkeit, also ohne Zuhilfenahme mechanisch wirkender, nicht-fluidischer seitlicher Kanten, Begrenzer oder sonstiger mechanischer Führungshilfen zum Halten oder Führen der Gegenstände. Auf diese Weise wird eine mechanische Beschädigung nicht nur der flächigen Seiten, sondern insbesondere auch der seitlichen umlaufenden Kanten der flachen Gegenstände zuverlässig vermieden. Zudem erlaubt die Erfindung eine gleichzeitige, z.B. nasschemische Behandlung der Gegenstände im Rahmen des Transportierens. Für das Vorschieben ermöglicht die Erfindung bevorzugt auch die Bereitstellung einer Vorschubkraft mittels der strömenden Flüssigkeit. Alternativ, insbesondere im Hinblick auf exakt einzuhaltende Behandlungszeiten, kann eine Vorschubeinrichtung vorgesehen sein, welche insbesondere für den Fall einer gleichzeitigen Behandlung der Gegenstände der Einhaltung exakter Behandlungszeiten dient. Die Erfindung ermöglicht ferner auch, die Substrate nicht nur in Transportrichtung zu bewegen, sondern auch vorübergehend anzuhalten, wobei die Substrate dabei nicht oder nur unwesentlich in mechanisch wirkenden Kontakt mit der Umgebung wie beispielsweise mechanische Stopper treten.

### Bezugszeichenliste und Abkürzungen

- 1: Substrat, flacher Gegenstand
- 1': Substratkante
- 2: Anströmbereich
- 3: Ablaufbereich
- 3': Ablaufrinne
- 4: Vorschubeinrichtung
- 4': Antriebsmittel
- 4": Vorschubmittel
- 5: Ultra- / Megaschallbehandlung
- 6: Durchtrittsöffnungen
- 7: Behandlungsfläche
- 8: Überlappbereich
- 9: Segmentgrenze
- 10: Winkel
- 11: Düsenbohrungen
- 12: Hohlraum
- 13: Einlass
- 14: Leiste
- F: Transport- bzw. Behandlungsflüssigkeit, Flüssigkeit
- V: Vorschubkraft
- K: Führungskraft
- T: Transportrichtung

## Patentansprüche

1. Verfahren zum Transportieren mindestens eines im Wesentlichen flachen und frei beweglichen Gegenstands (1) auf einer Flüssigkeit unter Verwendung einer Vorrichtung, welche mindestens eine Behandlungsfläche mit mindestens einem Anströmbereich (2), und mindestens einen seitlich an die Behandlungsfläche angrenzenden Ablaufbereich (3) umfasst, bei dem die zum Transport benötigte Flüssigkeit (F) aus dem mindestens einen Anströmbereich (2) der mindestens einen Behandlungsfläche derart ausgegeben wird, dass sie den flachen Gegenstand (1) anströmt, bevor sie in den mindestens einen seitlich zur Behandlungsfläche angeordneten Ablaufbereich (3) abläuft, wodurch zwischen dem flachen Gegenstand (1) und der Grenze zwischen Behandlungsfläche und Ablaufbereich eine den Gegenstand selbstzentrierende Adhäsionskraft erzeugt wird, durch welche der Gegenstand (1) ohne mechanische Führungshilfen auf der Flüssigkeit (F) gehalten und spurgetreu geführt werden kann.

2. Verfahren nach Anspruch 1, bei dem die Flüssigkeit (F) eine Behandlungsflüssigkeit ist.

3. Verfahren nach Anspruch 1 oder 2, bei dem zum Bewegen des flachen Gegenstands (1) zusätzlich eine Vorschubkraft (V) auf denselben ausgeübt wird.

4. Verfahren nach Anspruch 3, bei dem die Vorschubkraft (V) durch einen gerichteten Flüssigkeitsstrom bereitgestellt wird.

5. Verfahren nach Anspruch 3 oder 4, bei dem die Vorschubkraft (V) zusätzlich oder ausschließlich durch eine mechanisch wirkende Vorschubeinrichtung (4) bereitgestellt wird.

6. Vorrichtung zum Transportieren eines im Wesentlichen flachen und frei beweglichen Gegenstands (1) auf einer Flüssigkeit, umfassend
- mindestens eine Behandlungsfläche mit mindestens einem Anströmbereich (2) mit einer Mehrzahl von Durchtrittsöffnungen (6), aus welchen der flache Gegenstand (1) durch eine Flüssigkeit (F) anströmbar ist, und
- mindestens einen seitlich an die Behandlungsfläche angrenzenden Ablaufbereich (3) zum Ablaufen der Flüssigkeit (F) nach dem Anströmen,
wobei die Vorrichtung keine nicht-fluidischen Kanten, Begrenzer oder sonstige mechanische Führungshilfen zum Halten und Führen des flachen Gegenstands (1) umfasst und die Behandlungsfläche und der Ablaufbereich derart ausgestaltet sind, dass zwischen dem flachen Gegenstand (1) und der Grenze zwischen Behandlungsfläche und Ablaufbereich eine den Gegenstand selbstzentrierende Adhäsionskraft erzeugbar ist, durch welche der flache Gegenstand (1) ausschließlich durch den Strom aus Flüssigkeit (F) gehalten und geführt werden kann.

7. Vorrichtung nach Anspruch 6, bei der der Anströmbereich (2) als Teil einer ebenen Behandlungsfläche (7) ausgebildet ist.

8. Vorrichtung nach Anspruch 6 oder 7, bei der die Behandlungsfläche (7) stationär ausgebildet ist.

9. Vorrichtung nach einem der Ansprüche bis 6 bis 8, bei der die Behandlungsfläche (7) höchstens 4 mm und bevorzugt höchstens 3 mm breiter als der flache Gegenstand (1) ist.

10. Vorrichtung nach einem der Ansprüche bis 6 bis 9, bei der der Ablaufbereich (3) aus Bohrungen besteht oder als eine Ablaufrinne, als eine Lochleiste oder als gitterartige Öffnung ausgebildet ist.

11. Vorrichtung nach einem der Ansprüche bis 6 bis 10, wobei die Vorrichtung ferner eine aktive Absaugung der Flüssigkeit (F) aus dem Ablaufbereich (3) umfasst.

12. Vorrichtung nach einem der Ansprüche bis 6 bis 11, ferner umfassend Mittel zur Erzeugung einer auf den flachen Gegenstand (1) wirkenden Vorschubkraft (V).

13. Vorrichtung nach Anspruch 12, bei der die Vorschubkraft (V) über geneigte Durchtrittsöffnungen (6) des Anströmbereiches (2) der Behandlungsfläche (7) bereitgestellt wird.

14. Vorrichtung nach Anspruch 13, bei der die Durchtrittsöffnungen (6) in ihrer Neigung und/oder ihrem Querschnitt änderbar ausgestaltet sind.

15. Vorrichtung nach einem der Ansprüche 12 bis 14, bei der die Vorschubkraft (V) zusätzlich oder ausschließlich durch eine mechanisch wirkende Vorschubeinrichtung (4) bereitgestellt wird.

16. Vorrichtung nach Anspruch 15, wobei die Vorschubeinrichtung (4) ein Antriebsmittel (4'), welches aus der Gruppe bestehend aus Zahnriemen, Gliederketten, pneumatischen Zylindern, und Fluidpumpen ausgewählt ist, und mindestens ein Vorschubmittel (4") umfasst, welches aus der Gruppe bestehend aus mechanischen Anschlägen, Nocken, Rippen, Stiften, und Kratzbodenleisten ausgewählt ist, wobei das Vorschubmittel (4") bevorzugt jeweils nur auf die senkrecht zur Transportrichtung (T) stehende Kante des flachen Gegenstandes (1) wirkt.

17. Vorrichtung nach Anspruch 15 oder 16, wobei die Vorsrhnbeinrichtung (4) derart ausgestaltet ist, dass sie in Transportrichtung (T) antreibbar und gewünschtenfalls zusätzlich anhaltbar ist.

18. Vorrichtung nach einem der Ansprüche bis 6 bis 17, bei welcher die mindestens eine Behandlungsfläche (7) und/oder der mindestens eine Ablaufbereich (3) in einzelne Segmente mit Segmentgrenzen (9) unterteilbar ist, wobei an den Segmentgrenzen (9) Einrichtungen zum Anhalten des flachen Gegenstandes (1) angeordnet sind.

19. Vorrichtung nach Anspruch 18, bei der die Einrichtungen zum Anhalten als schließbare Ablaufrinnen, absenkbare Überlaufkanten, oder absenkbare und/oder schließbare Lochleisten ausgebildet sind.

20. Vorrichtung nach einem der Ansprüche bis 6 bis 19, bei der zusätzlich mindestens eine Behandlungsfläche (7) oberhalb des flachen Gegenstandes (1) angeordnet ist.

## Claims

1. Method for the transporting of at least one substantially flat and freely moveable object (1) on a liquid by use of an apparatus which comprises at least one treatment surface with at least one inflow region (2), and at least one discharge region (3) laterally adjoining the treatment surface, wherein the liquid (F) which is necessary for the transport is emitted from the at least one treatment surface's at least one inflow region (2) in such a manner that it streams against the flat object (1) before it discharges into the at least one discharge region (3) which is arranged laterally to the treatment surface, whereby an adhesion force that self-centers the object is generated between the flat object (1) and the boundary between treatment surface and discharge region by which the object (1) can be held and track-adherently guided on the liquid (F) without mechanical guiding aids.

2. Method according to claim 1, wherein the liquid (F) is a treatment liquid.

3. Method according to claim 1 or 2, wherein a feed force (V) is additionally exerted onto the flat object (1) for moving the same.

4. Method according to claim 3, wherein the feed force (V) is provided by a directed liquid stream.

5. Method according to claim 3 or 4, wherein the feed force (V) is additionally or exclusively provided by a mechanically acting feed device (4).

6. Apparatus for the transporting of a substantially flat and freely moveable object (1) on a liquid, comprising
- at least one treatment surface with at least one inflow region (2) with a multitude of pass-through openings (6) out of which the flat object (1) can be streamed against by a liquid (F), and
- at least one discharge region (3) laterally adjoining the treatment surface for discharging the liquid (F) after provision of the inflow,
wherein the apparatus does not comprise any non-fluidic edges, limiters, or other mechanical guiding aids for holding and guiding the flat object (1), and wherein the treatment surface and the discharge region are designed such that an adhesion force that self-centers the object can be generated between the flat object (1) and the boundary between treatment surface and discharge region, by which the flat object (1) can be held and guided exclusively by the stream of liquid (F).

7. Apparatus according to claim 6, wherein the inflow region (2) is formed as part of a flat treatment surface (7).

8. Apparatus according to claim 6 or 7, wherein the treatment surface (7) is formed stationary.

9. Apparatus according to any of claims 6 to 8, wherein the treatment surface (7) is not more than 4 mm and preferably not more than 3 mm wider than the flat object (1).

10. Apparatus according to any of claims 6 to 9, wherein the discharge region (3) consists of boreholes or is formed as a discharge groove, as a perforated strip, or as a lattice-like opening.

11. Apparatus according to any of claims 6 to 10, wherein the apparatus further comprises an active suction of the liquid (F) from the discharge region (3).

12. Apparatus according to any of claims 6 to 11, further comprising means for the generation of a feed force (V) which acts onto the flat object (1).

13. Apparatus according to claim 12, wherein the feed force (V) is provided by inclined pass-through openings (6) of the inflow region (2) of the treatment surface (7).

14. Apparatus according to claim 13, wherein the pass-through openings (6) are designed changeable in their inclination and/or in their cross section.

15. Apparatus according to any of claims 12 to 14, wherein the feed force (V) is additionally or exclusively provided by a mechanically acting feed device (4)

16. Apparatus according to claim 15, wherein the feed device (4) comprises a drive means (4') which is selected from the group consisting of drive belts, link chains, pneumatic cylinders, and fluid pumps, and at least one feed means (4") which is selected from the group consisting of mechanical end stops, cams, ribs, pins, and scraper floor rails, wherein the feed means (4") preferably only acts onto the flat object's (1) edge which stands perpendicular to the transport direction (T).

17. Apparatus according to claim 15 or 16, wherein the feed device (4) is designed in such a manner that it is drivable in transport direction (T) and optionally additionally stoppable.

18. Apparatus according to any of claims 6 to 17, wherein the at least one treatment surface (7) and/or the at least one discharge region (3) can be separated into individual segments with segment borders (9), wherein devices for stopping the flat object (1) are arranged at the segment borders (9).

19. Apparatus according to claim 18, wherein the devices for stopping are designed as closable discharge grooves, as lowerable overflow edges, or as lowerable and/or closable perforated strips.

20. Apparatus according to any of claims 6 to 19, wherein at least one treatment surface (7) is additionally arranged above the flat object (1).

## Revendications

1. Procédé pour le transport d'au moins un objet (1) en substance plat et libre de ses mouvements sur un liquide en utilisant un dispositif qui comprend au moins une surface de traitement avec au moins une région d'affluence(2), et au moins un système d'évacuation (3) limitrophe au coté de la surface de traitement, selon lequel le liquide (F) nécessaire au transport qui sort de la, au moins une, région d'affluence est appliqué de telle manière sur la, au moins une, surface de traitement qu'il afflue vers l'objet plat (1) avant de se déverser dans le, au moins un, système d'évacuation (3) limitrophe au coté de la surface de traitement, de par quoi entre l'objet plat (1) et la limite entre la surface de traitement et le système d'évacuation se crée une force d'adhésion capable par elle-même de centrer l'objet, par laquelle l'objet (1) peut être sans aide mécanique de guidage être tenu sur le liquide (F) et peut être guidé fidèlement sur une ligne.

2. Procédé selon la revendication 1 dans lequel le liquide (F) est un liquide de traitement.

3. Procédé selon la revendication 1 ou la revendication 2 dans lequel une force de propulsion (V) additionnelle pour le mouvement vers l'avant de l'objet plat (1) est exercée sur celui-ci.

4. Procédé selon la revendication 3 dans lequel la force de propulsion (V) est mise en place par un flux de liquide dirigé.

5. Procédé selon la revendication 3 ou la revendication 4 dans lequel la force de propulsion (V) est mise en place additionnellement ou exclusivement par un dispositif mécanique de déplacement vers l'avant (4).

6. Dispositif pour le transport d'au moins un objet (1) en substance plat et libre de ses mouvements sur un liquide comprenant:
- au moins une surface de traitement avec au moins une région d'affluence (2) avec une pluralité d'ouvertures (6) desquelles afflue un liquide (F) vers l'objet plat (1), et
- au moins un système d'évacuation (3) limitrophe au coté de la surface de traitement pour l'évacuation du liquide (F) après l'écoulement,
le dispositif ne comprenant pas d'arête non formée de fluide, pas de limiteur ou autres aides de guidage mécanique pour tenir ou guider l'objet plat (1), et la surface de traitement et le système d'évacuation étant conçus de telle manière que, entre l'objet plat (1) et la limite entre la surface de traitement et le système d'évacuation peut être créée une force d'adhésion capable par elle-même de centrer l'objet, par laquelle l'objet plat (1) peut être tenu et guidé exclusivement par l'écoulement du liquide.

7. Dispositif selon la revendication 6 dans lequel la région d'affluence (2) se présente comme une partie d'une surface de traitement plane (7).

8. Dispositif selon la revendication 6 ou la revendication 7 dans lequel la surface de traitement (7) est stationnaire.

9. Dispositif selon une des revendications 6 à 8 dans lequel la surface de traitement (7) est au maximum 4 mm et préférentiellement 3 mm plus large que l'objet plat (1).

10. Dispositif selon une des revendications 6 à 9 dans lequel le système d'évacuation (3) est constitué d'orifices ou est formé comme une gouttière, comme un rail perforé ou comme une ouverture en grille.

11. Dispositif selon une des revendications 6 à 10, le dispositif comprenant de plus une aspiration active du liquide (F) hors du système d'évacuation (3).

12. Dispositif selon une des revendications 6 à 11 comprenant de plus un agent pour la génération d'une force de propulsion (V) agissant sur l'objet plat (1).

13. Dispositif selon la revendication 12 dans lequel la force de propulsion (V) est mise en place par des ouvertures (6) inclinées dans la région d'affluence (2) de la surface de traitement (7).

14. Procédé selon la revendication 13 dans lequel les ouvertures (6) sont modifiables au niveau de leur inclinaison et/ou leur diamètre.

15. Dispositif selon une des revendications 12 à 14 dans lequel la force de propulsion (V) est mise en place additionnellement ou exclusivement par un dispositif mécanique de déplacement vers l'avant (4).

16. Dispositif selon la revendication 15 dans lequel le dispositif de déplacement vers l'avant (4) comprend un dispositif moteur (4') qui est choisi dans un groupe composé de courroies crantées, de chaînes articulées, de cylindres pneumatiques et de pompes à fluide, et au moins un moyen de déplacement vers l'avant (4") qui est choisi dans un groupe composé de butées mécaniques, d'ergots, de clavettes, de picots et de formes à traverse, le moyen de déplacement vers l'avant (4") agissant préférentiellement uniquement sur l'arête de chaque objet plat (1) qui est perpendiculaire à la direction de transport (T).

17. Dispositif selon la revendication 15 ou la revendication 16 dans lequel le dispositif de déplacement vers l'avant (4) est conçu de telle manière qu'il peut avancer dans la direction de transport (T) et en plus si souhaité être arrêté.

18. Dispositif selon une des revendications 6 à 17 dans lequel la, au moins une, surface de traitement (7) et/ou le, au moins un, système d'évacuation (3) sont divisibles en segments isolés avec des frontières entre les segments (9), des dispositifs pour arrêter l'objet plat (1) étant localisés au niveau des frontières entre les segments (9).

19. Dispositif selon la revendication 18 dans lequel les dispositifs pour l'arrêt sont conçus comme des gouttières fermables, des seuils d'évacuation abaissables, ou des rails perforés abaissables et/ou fermables.

20. Dispositif selon une des revendications 6 à 19 dans lequel de plus au moins une surface de traitement (7) est localisée au dessus de l'objet plat (1).
